(19) Europäisches Patentamt
European Patent Office
Office européen des brevets

(11) EP 2 511 969 A1

(12) **EUROPEAN PATENT APPLICATION**
published in accordance with Art. 153(4) EPC

(43) Date of publication:
**17.10.2012 Bulletin 2012/42**

(21) Application number: **10836088.4**

(22) Date of filing: **10.12.2010**

(51) Int Cl.:
***H01L 51/50*** *(2006.01)* ***C09K 11/06*** *(2006.01)*

(86) International application number:
**PCT/JP2010/072292**

(87) International publication number:
**WO 2011/071169 (16.06.2011 Gazette 2011/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.12.2009 JP 2009281978**

(71) Applicant: **Mitsubishi Chemical Corporation**
**Chiyoda-ku**
**Tokyo 100-8251 (JP)**

(72) Inventors:
- **ABE Tomohiro**
  **Kanagawa 227-8502 (JP)**
- **TAKAHASHI Atsushi**
  **Kanagawa 227-8502 (JP)**

(74) Representative: **HOFFMANN EITLE**
**Patent- und Rechtsanwälte**
**Arabellastrasse 4**
**81925 München (DE)**

(54) **ORGANIC ELECTROLUMINESCENT ELEMENT, ORGANIC EL DISPLAY DEVICE, AND ORGANIC EL LIGHTING**

(57) An electron affinity and an ionization potential of a luminescent material and a charge transport material contained in a luminescent layer and those of hole transport layer satisfy a specific relationship, and a hole transport layer comprises a compound which has a specific partial structure.

[Fig. 1]

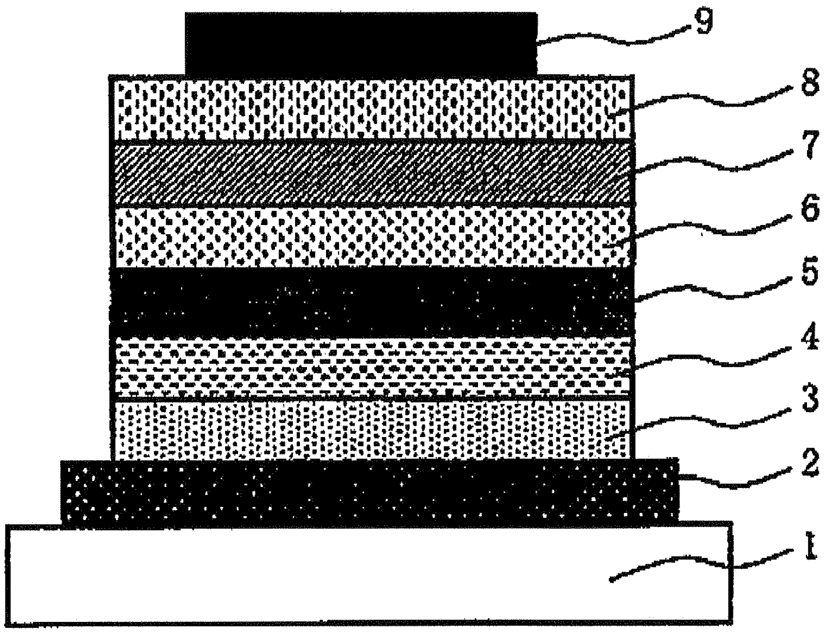


EP 2 511 969 A1

Printed by Jouve, 75001 PARIS (FR)

## Description

Technical Field

The present invention relates to an organic electroluminescent element which has a hole transport layer and a luminescent layer. The invention further relates to an organic EL display device and an organic EL illuminator both including the organic electroluminescent element.

Background Art

In recent years, organic electroluminescent (organic EL) elements are being developed enthusiastically as a technique for producing light-emitting devices for displays, illuminators, and the like. Organic electroluminescent elements generally can be made to emit light of various colors using a simple element configuration, and hence are receiving attention as display elements and illuminators.

In an organic electroluminescent element, positive and negative charges (carries) are injected from electrodes into an organic layer interposed between the electrodes and the carries are recombined in the organic layer to thereby cause the organic layer to luminesce. It is said that an improvement in luminescent efficiency and a prolongation of working life are required for the practical use of organic electroluminescent elements.

In order to overcome problems concerning luminescent efficiency and working life, patent documents 1 to 4, for example, describe techniques in which a relationship between the ionization potential of a charge transport material contained in a luminescent layer and that of the material constituting a hole transport layer which adjoins the luminescent layer on the anode side thereof is specified or a relationship between the ionization potential of a charge-transporting material contained in a luminescent layer and that of a luminescent material contained in the luminescent layer is specified.

Prior-Art Documents

Patent Documents

Patent Document 1: JP-A-2007-311759
Patent Document 2: U.S. Patent No. 2009/0200925
Patent Document 3: JP-A-2006-352088
Patent Document 4: JP-A-2006-128636

Summary of the Invention

Problem that the Invention is to Solve

However, an element which has a long working life has not always been obtained with any of patent documents 1 to 4.

Accordingly, a subject for the invention is to provide an organic electroluminescent element which has a luminescent layer and a hole transport layer that adjoins the luminescent layer on the anode side thereof and which has a high luminescent efficiency and a long working life.

Means for Solving the Problem

In view of those circumstances, the present inventors diligently made investigations while directing attention to a relationship between electron affinity and ionization potential with respect to a charge transport material and a luminescent material both contained in a luminescent layer and to a hole-transporting compound contained in a hole transport layer that adjoins the luminescent layer.

As a result, the inventors found that an organic electroluminescent element having a high luminescent efficiency and a long working life is obtained by preventing electrons which the luminescent material has received from a layer located on the cathode side of the luminescent layer from being further transferred to the hole-transporting compound contained in the hole transport layer and by preventing holes which the hole-transporting compound contained in the hole transport layer has received from a layer located on the anode side thereof from being further transferred to the luminescent material contained in the luminescent layer.

The inventors diligently made further investigations, As a result, the inventors have found that the subject is

accomplished by employing a specific relationship between electron affinity and ionization potential with respect to the luminescent material and charge transport material which are contained in the luminescent layer and to the hole-transporting compound contained in the hole transport layer, and by incorporating a hole-transporting compound of a specific structure into the hole transport layer. The invention has been thus achieved.

Namely, essential points of the invention are as follows.

1. An organic electroluminescent element comprising an anode, a hole transport layer, a luminescent layer and a cathode, in this order, wherein
the hole transport layer and the luminescent layer have been disposed so as to adjoin each other,
the luminescent layer is a layer which comprises a luminescent material and a charge transport material,
the hole transport layer comprises a hole-transporting compound which has a partial structure shown by the following general formula (5), and
the organic electroluminescent element satisfies the following expressions (1) to (4).

$$EA_{HTL} < EA_{Dopant} \leq EA_{Host} \quad (1)$$

$$0 \leq (EA_{Host} - EA_{Dopant}) \leq 0.7\ eV \quad (2)$$

$$IP_{Dopant} < IP_{HTL} \leq IP_{Host} \quad (3)$$

$$0 \leq (IP_{Host} - IP_{Dopant}) \leq 0.7\ eV \quad (4)$$

[In the expressions, $EA_{HTL}$ represents an electron affinity (eV) of the hole-transporting compound,
$EA_{Dopant}$ represents an electron affinity (eV) of the luminescent material,
$EA_{Host}$ represents an electron affinity (eV) of the charge transport material,
$IP_{HTL}$ represents an ionization potential (eV) of the hole-transporting compound,
$IP_{Dopant}$ represents an ionization potential (eV) of the luminescent material, and
$IP_{Host}$ represents an ionization potential (eV) of the charge transport material.]

[Chem. 1]

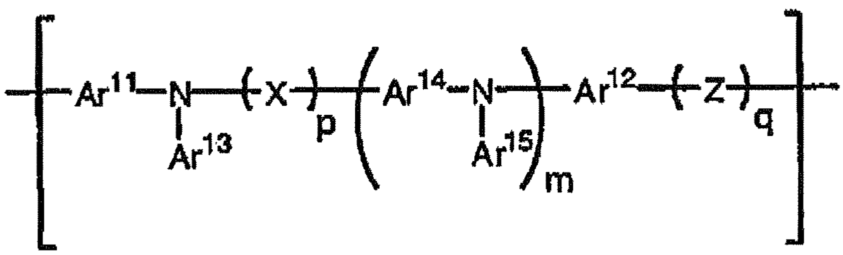

(5)

(In the formula, m represents an integer of 0 to 3, p and q represent an integer of 0 or 1, and
$Ar^{11}$ and $Ar^{12}$ each independently represent a direct bond or an aromatic group which may have a substituent, both of $Ar^{11}$ or $Ar^{12}$ being not a direct bond.
$Ar^{13}$ to $Ar^{15}$ each independently represent an aromatic group which may have a substituent, and when m is 2 or 3, the two or three $Ar^{14}$ groups may be the same or different and the two or three $Ar^{15}$ groups may be the same or different.
X represents an oxygen atom, a sulfur atom which may have a substituent, or a phosphorus atom which may have a substituent.
Z represents a divalent linking group, and
the substituents possessed by $Ar^{11}$ to $Ar^{13}$, $Ar^{15}$, X, and Z each have 60 carbon atoms or less, and the substituent possessed by $Ar^{14}$ has 6 carbon atoms or less.)

2. The organic electroluminescent element according to the item l above, wherein m in general formula (5) represents an integer of 1 to 3.
3. The organic electroluminescent element according to the item 1 or 2 above, which further comprises a hole injection layer between the anode and the hole transport layer.
4. The organic electroluminescent element according to any one of the items 1 to 3 above, wherein the luminescent material is at least one of a fluorescent material and a phosphorescent material.
5. An organic EL display device comprising the organic electroluminescent element according to any one of the items 1 to 4 above.
6. An organic EL illuminator comprising the organic electroluminescent element according to any one of the items 1 to 4 above.

Effects of the Invention

The organic electroluminescent element of the invention has a high luminescent efficiency and a long working life.

Brief Description of the Drawing

[Fig. 1] Fig. 1 is a diagrammatic view illustrating an example of the cross-sectional structure of an organic electroluminescent element of the invention.

Modes for Carrying Out the Invention

Embodiments of the invention are explained below in detail. However, the following explanations are for embodiments (representative embodiments) of the invention, and the invention should not be construed as being limited to the embodiments unless the invention departs from the spirit thereof.

<Basic Configuration>

The organic electroluminescent element of the invention includes an anode, a hole transport layer, a luminescent layer, and a cathode in this order. In the organic electroluminescent element of the invention, the hole transport layer and the luminescent layer adjoin each other. The luminescent layer contains a luminescent material and a charge transport material. Furthermore, the organic electroluminescent element of the invention satisfies the following expressions (1) to (4).

$$EA_{HTL} < EA_{Dopant} \leq EA_{Host} \qquad (1)$$

$$0 \leq (EA_{Host} - EA_{Dopant}) \leq 0.7\ eV \qquad (2)$$

$$IP_{Dopant} < IP_{HTL} \leq IP_{Host} \qquad (3)$$

$$0 \leq (IP_{Host} - IP_{Dopant}) \leq 0.7\ eV \qquad (4)$$

In the expressions, $EA_{HTL}$ represents the electron Affinity (eV) of the hole-transporting compound,
$EA_{Dopunt}$ represents the electron affinity (eV) of the luminescent material,
$EA_{Host}$ represents the electron affinity (eV) of the charge transport material,
$IP_{HTL}$ represents the ionization potential (eV) of the hole-transporting compound,
$IP_{Dopant}$ represents the ionization potential (eV) of the luminescent material, and
$IP_{Host}$ represents the ionization potential (eV) of the charge transport material.

[Hole Transport Layer]

The hole transport layer in the invention is a layer which lies between the anode and the luminescent layer and which has the function of transporting holes from the anode side to the luminescent-layer slide.

When two or more organic layers which have the function of transporting holes from the anode side to the luminescent-layer side are present between the anode and the luminescent layer, then the organic layer which is located on the most luminescent-layer side is referred to as a hole transport layer and the other layer or layers are referred to as a hole injection layer.

(Hole-Transporting Compound)

The hole transport layer in the invention contains a hole-transporting compound which includes a partial structure represented by the following formula (5).

[Chem. 2]

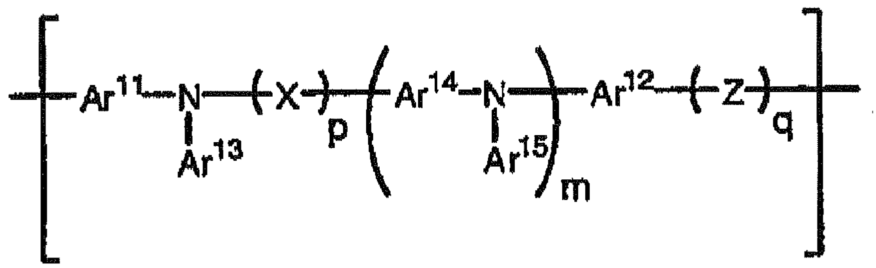

(5)

(In the formula, m represents an integer of 0 to 3, and p and q represent an integer of 0 or 1.
$Ar^{11}$ and $Ar^{12}$ each independently represent a direct bond or an aromatic group which may have a substituent, both of $Ar^{11}$or $Ar^{12}$ being not a direct bond.
$Ar^{13}$ to $Ar^{15}$ each independently represent an aromatic group which may have a substituent, and when m is 2 or 3, the two or three $Ar^{15}$ groups may be the same or different.
X represents an oxygen atom, a sulfur atom which may have a substituent, or a phosphorus atom which may have a substituent.
Z represents a divalent linking group.
The substituents possessed by $Ar^{11}$ to $Ar^{13}$, $Ar^{15}$, X, and Z each have 60 carbon atoms or less, and the substituent possessed by $Ar^{14}$ has 6 carbon atoms or less.)

When the hole transport layer in the invention contains an organic compound including a partial structure represented by formula (5), this configuration prevents electrons which the luminescent material has received from a layer located on the cathode side of the luminescent layer from being further transferred to the hole-transporting compound contained in the hole transport layer and prevents holes which the hole-transporting compound contained in the hole transport layer has received from a layer located on the anode side thereof from being further transferred to the luminescent material contained in the luminescent layer. This configuration hence makes it easy to obtain an organic electroluminescent element which has a high luminescent efficiency and a long working life. In addition, it is easy to satisfy expressions (1) to (4) given above.

[$Ar^{11}$ to $Ar^{15}$]

In formula (5), $Ar^{11}$ and $Ar^{12}$ each independently represent a direct bond or an aromatic group which may have a substituent. However, both of $Ar^{11}$ or $Ar^{12}$ is not a direct bond. It is preferred that $Ar^{11}$ and $Ar^{12}$ each should be an aromatic group which may have a substituent. $Ar^{13}$ to $Ar^{15}$ each independently represent an aromatic group which may have a substituent.

The aromatic groups which may have a substituent each may be either a group derived from an aromatic hydrocarbon ring or a group derived from an aromatic heterocycle, so long as the aromatic group is a group derived from a ring having aromaticity. Furthermore, the aromatic groups which may have a substituent each may be either a group derived from a monocycle having aromaticity, a group derived from a fused ring having aromaticity, or a group derived from a plurality of rings linked to each other and having aromaticity.

In particular, it is preferred that the number of rings having aromaticity should be 1 (a monocycle) or more, and

the number thereof is more preferably 2 (a dicyclic fused ring or a ring configured of two linked monocycles) or more. Meanwhile, the number thereof is preferably 5 (a pentacyclic fused ring, a ring configured of a dicyclic fused ring and a tricyclic fused ring linked thereto, a ring configured of five linked monocycles, etc,) or less, more preferably 4 (a tetracyclic fused ring, a ring configured of two dicyclic fused rings linked to each other, a ring configured of four linked monocycles, etc.) or less, even more preferably 3 (a tricyclic fused ring, a ring configured of a monocycle and a dicyclic fused ring linked thereto, or a ring configured of three linked monocycles) or less.

Examples of the aromatic hydrocarbon ring group which may have a substituent include groups derived from 6-membered monocycles or di- to pentacyclic fused rings, such as a benzene ring, naphthalene ring, anthracene ring, phenanthrene ring, perylene ring, tetracene ring, pyrene ring, benzpyrene ring, chrysene ring, triphenylene ring, acenaphthene ring, fluoranthene ring, and fluorene ring, and further include groups configured of two to five monocycles or fused rings linked to each other, such as a biphenylene group, a terphenylene group, and a quaterphenylene group. With respect to an aromatic group including a branch, the branch portion (side-chain portion) of the aromatic group is regarded as a substituent.

Examples of the aromatic heterocyclic group which may have a substituent include groups derived from 5- or 6-membered monocycles and from di- to tetracyclic fused rings in which each cycle is 5- or 6-membered, such as a furan ring, benzofuran ring, thiophene ring, benzothiophene ring, pyrrole ring, pyrazole ring, imidazole ring, oxadiazole ring, indole ring, pyrroloimidazole ring, pyrrolopyrazole ring, pyrrolopyrrole ring, thienopyrrole ring, thienothiophene ring, furopyrrole ring, furofuran ring, thienofuran ring, benzoisooxazole ring, benzoisothiazole ring, benzoimidazole ring, pyridine ring, pyrazine ring, pyridazine ring, pyrimidine ring, triazine ring, quinoline ring, isoquinoline ring, cinnoline ring, quinoxaline ring, phenanthridine ring, benzimidazole ring, perimidine ring, quinazoline ring, quinazolinone ring, and azulene ring. With respect to an aromatic heterocyclic group including a branch, the branch portion (side-chain portion) of the aromatic heterocyclic group is regarded as a substituent.

From the standpoints of solubility in organic solvents and heat resistance, preferred examples of $Ar^{11}$ to $Ar^{15}$, among those, are groups derived from monocycles or di- to tetracyclic fused rings, such as a benzene ring, naphthalene ring, anthracene ring, phenanthrene ring, biphenyl ring, terphenyl ring, triphenyl ring, phenylnaphthalene ring, pyrene ring, thiophene ring, pyridine ring, and fluorene ring.

Especially from the standpoints of oxidation/reduction resistance and hole transport properties, $Ar^{11}$ to $Ar^{15}$ preferably are aromatic hydrocarbon ring groups, and most preferably are a benzene ring, naphthalene ring, biphenyl ring, triphenyl ring, and phenylnaphthalene ring.

The substituents which may be possessed by the aromatic groups represented by $Ar^{11}$ to $Ar^{13}$ and $Ar^{15}$ are not particularly limited in the number of carbon atoms so long as the number thereof in each substituent is 60 or less. The substituent which may be possessed by the aromatic group represented by $Ar^{14}$ is not particularly limited so long as the substituent has 6 carbon atoms or less. $Ar^{11}$ to $Ar^{15}$ may have been bonded to each other either directly or through a linking group to form a cyclic structure. Examples of the substituents which may be possessed by the aromatic groups represented by $Ar^{11}$ to $Ar^{15}$ include any substituents selected from the following [Substituents D].

[Substituents D]

[Substituents D] include: alkyl groups such as methyl and ethyl; alkenyl groups such as vinyl; alkynyl groups such as ethynyl; alkoxy groups such as methoxy and ethoxy; aryloxy groups such as phenoxy, naphthoxy, and pyridyloxy; alkoxycarbonyl groups such as methoxycarbonyl and ethoxycarbonyl; dialkylamino groups such as dimethylamino and diethylamino; diarylamino groups such as diphenylamino, ditolylamino, and N-carbazolyl; arylalkylamino groups such as phenylmethylamino; acyl groups having preferably 2-24 carbon atoms, more preferably 2-12 carbon atoms, such as acetyl and benzoyl; halogen atoms such as fluorine and chlorine atoms; haloalkyl groups such as trifluoromethyl; alkylthio groups such as methylthio and ethylthio; arylthio groups such as phenylthio and naphthylthio; silyl groups such as trimethylsilyl and triphenylsilyl; siloxy groups such as trimethylsiloxy and triphenylsiloxy; cyano; aromatic hydrocarbon ring groups such as phenyl and naphthyl; and aromatic heterocyclic groups such as thienyl and pyridyl.

The terms "aromatic hydrocarbon ring group" and "aromatic heterocyclic group" mean the aromatic hydrocarbon ring group or aromatic heterocyclic group which constitutes the branch portion when that aromatic hydrocarbon ring group or aromatic heterocyclic group has a branch.

It is preferred that the number of carbon atoms of [Substituents D] should be smaller from the standpoint of unsusceptibility to oxidative deterioration. Specifically, the number of carbon atoms of [Substituents D] is preferably 2 or move, more preferably 4 or more, especially preferably 5 or more. Meanwhile, the number thereof is preferably 36 or less, more preferably 24 or less, especially preferably 12 or less, most preferably 6 or less.

Specific examples of preferred substituents in [Substituents D] include: alkyl, alkoxy, and alkylthio groups having 1-24 carbon atoms; alkenyl, alkynyl, alkoxycarbonyl, dialkylamino, and acyl groups having 2-24 carbon atoms; aryloxy and arylthio groups having 4-36 carbon atoms; diarylamino groups having 10-36 carbon atoms; arylalkylamino and aromatic hydrocarbon groups having 6-36 carbon atoms; haloalkyl groups having 1-12 carbon atoms; silyl and siloxy

groups having 2-36 carbon atoms; and aromatic heterocyclic groups having 3-36 carbon atoms.

Examples of more preferred substituents include: alkyl, alkoxy, and alkylthio groups having 1-12 carbon atoms; alkenyl, alkynyl, alkoxycarbonyl, dialkylamino, and acyl groups having 2-12 carbon atoms; aryloxy groups having 5-24 carbon atoms; diarylamino groups having 12-24 carbon atoms; arylalkylamino groups having 7-24 carbon atoms; haloalkyl groups having 1-6 carbon atoms; arylthio groups having 5-24 carbon atoms; silyl groups having 3-24 carbon atoms; siloxy groups having 3-24 carbon atoms; aromatic hydrocarbon groups having 6-24 carbon atoms; and aromatic heterocyclic groups having 4-24 carbon atoms.

From the standpoint of solubility in organic solvents, especially preferred examples of the substituents which may be possessed by the aromatic rings represented by $Ar^{11}$ to $Ar^{15}$ are the alkyl groups and the alkoxy groups among those.

The aromatic groups represented by $Ar^{11}$ to $Ar^{15}$ each may have one substituent bonded thereto or two or more substituents bonded thereto. In the case where the aromatic group has a plurality of substituents bonded thereto, the substituents may be of one kind, or two or more kinds of substituents may have been bonded in any desired positions. These substituents may further have substituents.

It is preferred that the molecular weight of the substituent which may be possessed by each of the aromatic groups represented by $Ar^{11}$ to $Ar^{15}$ should be lower. Specifically, the molecular weight of the substituent which may be possessed by each of the aromatic groups represented by $Ar^{11}$ to $Ar^{15}$ is preferably 500 or less, more preferably 250 or less, in terms of total molecular weight including the molecular weight of any further substituent(s).

[m]

In formula (5), m represents an integer of 0-3. It is especially preferred that m should be an integer of 1-3. However, it is preferred that m should be smaller from the standpoint of ease of starting-material synthesis. Specifically, it is preferred that m should be 2 or less.

It is preferred that when m is 2 or larger, then the organic compound including a partial structure represented by formula (5) should have two or more $Ar^{14}$ groups and two or more $Ar^{15}$ groups. In this case, the multiple $Ar^{14}$ groups may be the same or different and the multiple $Ar^{15}$ groups may be the same or different. Furthermore, the $Ar^{14}$ groups may have been bonded to each other either directly or through a linking group to form a cyclic structure, and the $Ar^{15}$ groups also may have been bonded to each other either directly or through a linking group to form a cyclic structure.

[X]

In formula (5), X represents an oxygen atom, a sulfur atom which may have a substituent, or a phosphorus atom which may have a substituent.

The substituent which may be possessed by the sulfur atom or phosphorus atom represented by X is not particularly limited. However, the [Substituents D], for example, are preferred. The number of substituents possessed by X and the molecular weight thereof also are preferably the same as in the case of the substituents which may be possessed by the aromatic groups represented by $Ar^{11}$ to $Ar^{13}$ and $Ar^{15}$.

[p]

In formula (5), p represents an integer of 0 or 1.

In the case where p is 0, the conjugated system in the partial structure represented by formula (5) is shorter than in the case where p is 1, resulting in a wider energy gap. Consequently, when a wider energy gap is desired, it is preferred that p should be 0. On the other hand, when a narrower energy gap is desired, it is preferred that p should be 1.

[Z]

In general formula (5), Z represents a divalent linking group. Examples of the divalent linking agent include an oxygen atom, -CO-, a sulfur atom which may have a substituent, and a phosphorus atom having a substituent. Examples of the sulfur atom which may have a substituent include -SO- and $—SO_2$-. Examples of the phosphorus atom having a substituent include $—P(=O)Ar^{a11}$-.

The substituents possessed by the sulfur atom and phosphorus atom are not particularly limited. However, the [Substituents D], for example, are preferred. The number of substituents and the molecular weight thereof also are preferably the same as in the case of the substituents which may be possessed by the aromatic groups represented by $Ar^{11}$ to $Ar^{13}$ and $Ar^{15}$.

$Ar^{a11}$ represents an aromatic group which may have a substituent. Preferred examples of $Ar^{a11}$ are the same as the examples of $Ar^{11}$ to $Ar^{13}$ and $Ar^{15}$ given above.

A group represented by the following formula (XI) also is preferred as the divalent linking group represented by Z.
[Chem. 3]

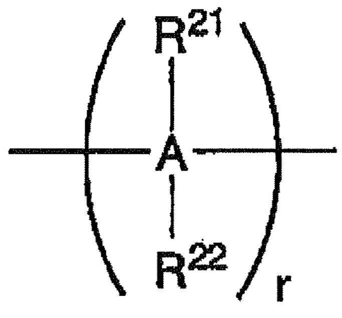

(X I)

(Symbol A represents a silicon atom, an alkylene group having 1-20 carbon atoms, an alkenylene group, an alkylacetylene group, or an aromatic heterocyclic group which has 4-40 carbon atoms and may have a substituent.
$R^{21}$ and $R^{22}$ each independently represent a hydrogen atom, an oxygen atom which may have a substituent, a nitrogen atom which may have a substituent, a sulfur atom which may have a substituent, an alkyl group which may have a substituent, an alkynyl group which may have a substituent, an alkynyl group which may have a substituent, or an aromatic hydrocarbon ring group or aromatic heterocycle which may have a substituent,
Symbol r represents an integer of 1-3.)
It is preferred that Z should be a divalent group selected from the following linking groups, among those examples, from the standpoint that the following linking groups bring about an improvement in durability to oxidation/reduction.

<Linking Groups>

[Chem. 4]

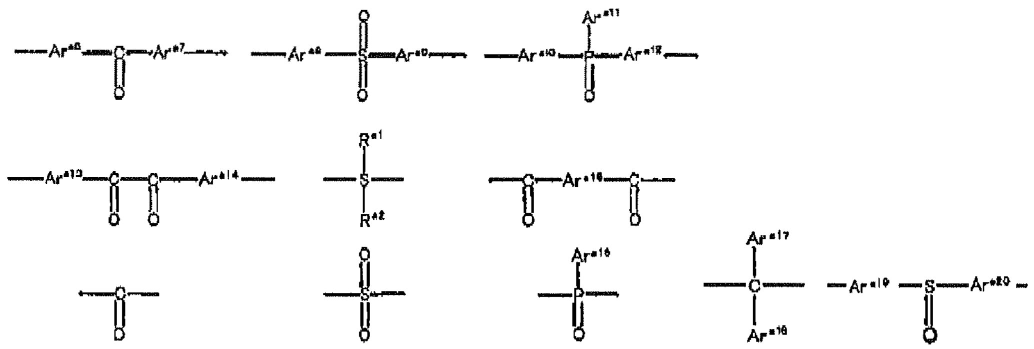

(In the formulae, $Ar^{a6}$ to $Ar^{a20}$ each independently represent an aromatic hydrocarbon ring group which may have a substituent or an aromatic heterocyclic group which may have a substituent,
$R^{a1}$ and $R^{a2}$ each independently represent a hydrogen atom, an alkyl group which may have a substituent, an alkynyl group which may have a substituent, an alkynyl group which may have a substituent, or an aromatic hydrocarbon ring group or aromatic heterocycle which may have a substituent.)

[q]

In formula (5), q represents an integer of 0 or 1. Since Z makes a limited contribution to charge transport properties, it is preferred that q should be 0.
In the case where q is 0, the conjugated system in the partial structure represented by formula (5) is shorter than in the case where q is 1, resulting in a wider energy gap. Consequently, when a wider energy gap is desired, it is preferred that q should be 0. On the other hand, when a narrower energy gap is desired, it is preferred that q should be 1.

[Insolubilizing Group]

It is preferred that the hole-transporting compound contained in the hole transport layer according to the invention should contain a group derived from an insolubilizing group, because it is easy to superpose another layer on this hole transport layer by a wet film formation method.

The term "insolubilizing group" in the invention means a group which has the effect of reducing the solubility of a compound having the group in solvents such as organic solvents and water upon heating and/or irradiation with actinic energy rays or the like. The term "group derived from an insolubilizing group" in the invention means a group into which the insolubilizing group has changed upon heating and/or irradiation with actinic energy rays or the like.

It is especially preferred that the hole-transporting compound contained in the hole transport layer according to the invention should contain both a partial structure represented by formula (5) and a group derived from an insolubilizing group. The hole-transporting compound contained in the hole transport layer according to the invention may have only one group derived from an insolubilizing group, or two or more insolubilizing-group-derived groups of any desired kind (s) may be possessed by the compound in any desired proportion.

In the invention, the insolubilizing group preferably is a dissociable group or a crosslinkable group, and especially preferably is a crosslinkable group.

In the case where the hole-transporting compound containing a partial structure represented by formula (5) further has a group derived from an insolubilizing group, the group derived from an insolubilizing group may be located in any position within formula (5). Namely, the group derived from an insolubilizing group may be contained in any of the $Ar^{11}$ to $Ar^{13}$, $Ar^{15}$, X, and Z within formula (5), Furthermore, the group derived from an insolubilizing group may be contained as a partial structure other than the partial structure represented by formula (5).

In the case where the group derived from an insolubilizing group is contained as a partial structure other than the partial structure represented by formula (5), it is preferred that the group derived from an insolubilizing group should be bonded to the partial structure represented by formula (5) either directly or through a divalent group. This divalent group preferably is a —O- group, a —C(=O)- group, or a —$CH_2$-group which may have a substituent. The hole-transporting compound may have one of these divalent linking groups or may have any desired combination of two or more thereof. In the case where the compound has a plurality of such divalent linking groups, it is preferred that the number of these divalent linking groups should be 3 or less because this compound is excellent in terms of resistance to oxidation/ reduction and charge transport properties. It is most preferred that the group derived from an insolubilizing group should have been directly bonded without through a divalent linking group.

It is preferred that the hole-transporting compound layer according to the invention should have both a partial structure which is represented by formula (5) and has a group derived from an insolubilizing group and a partial structure which is represented by formula (5) and has no group derived from an insolubilizing group.

(Dissociable Group)

It is preferred that the hole transport layer according to the invention should contain a hole-transporting compound which has a group derived from a dissociable group as a group derived from an insolubilizing group, from the standpoint that this hole transport layer has an excellent charge-transporting ability after insolubilization (after dissociation reaction).

The term "dissociable group" herein means a group which has the effect of causing the compound having the group to undergo a dissociation reaction upon heating and/or irradiation with actinic energy rays or the like and thereby reducing the solubility of the compound in solvents. The term "group derived from a dissociable group" in the invention means a group into which the dissociable group has changed upon heating and/or irradiation with actinic energy rays or the like.

The solubility in toluene of the hole-transporting compound having a dissociable group (the hole-transporting compound which has not undergone a dissociation reaction) according to the invention, at 25°C and 1 atm, is preferably 0.1% by weight or more, more preferably 0.5% by weight or more, especially preferably 1% by weight or more.

The dissociable group preferably is a group which dissociates without leaving a polar group in the hole-transporting compound which contains a partial structure represented by formula (5) and which has undergone the dissociation reaction. It is more preferred that the dissociable group should be a group which dissociates through a retro-Diels-Alder reaction. The dissociable group especially preferably is a group which thermally dissociates at 100°C or higher, and most preferably is a group which thermally dissociates at 300°C or lower.

Specific examples of the dissociable group are shown below, but the invention should not be construed as being limited to the examples.

In the case where the dissociable group is a divalent group, specific examples thereof include the groups shown under the following <Divalent Dissociable Groups E>.

<Divalent Dissociable Groups E>

[Chem. 5]

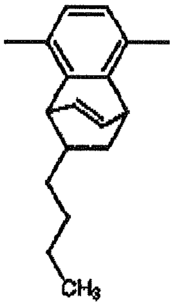

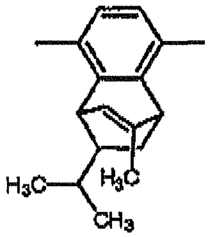

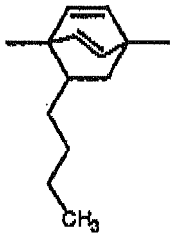

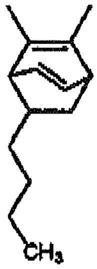

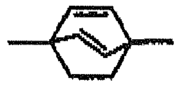

In the case where the dissociable group is a monovalent group, specific examples thereof include the groups shown under the following <Monovalent Dissociable Groups G>.

<Monovalent Dissociable Groups G1>

[Chem. 6]

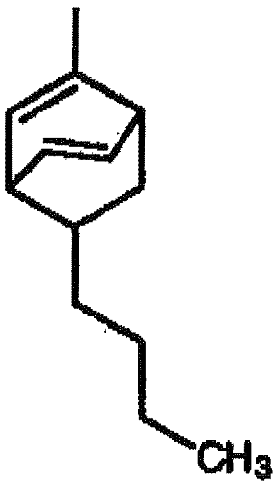

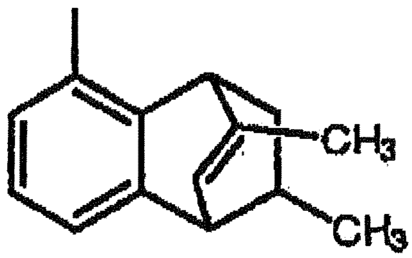

(Crosslinkable Group)

It is preferred that the hole transport layer according to the invention should contain a hole-transporting compound which has a group derived from a crosslinkable group as a group derived from an insolubilizing group, from the standpoint that this hole transport layer has an excellent hole-transporting ability after insolubilization (after crosslinking reaction).

The term "crosslinkable group" herein means a group which, upon heating and/or irradiation with actinic energy rays or the like, reacts with the same or a different group of another molecule to form a new chemical bond. The term "group derived from a crosslinkable group" in the invention means a group into which the crosslinkable group has changed upon heating and/or irradiation with actinic energy rays or the like.

Specific examples of the crosslinkable group are shown below, but the invention should not be construed as being limited to the examples. Examples of the crosslinkable group include the groups shown under Crosslinkable Groups G2, from the standpoint of ease of insolubilization.

[Crosslinkable Groups G2]

[Chem. 7]

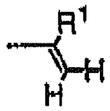
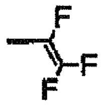
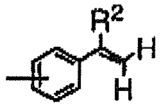
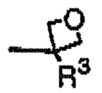
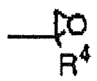
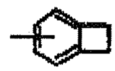

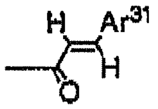
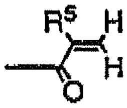
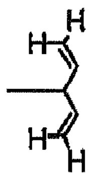
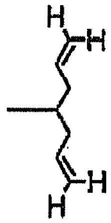
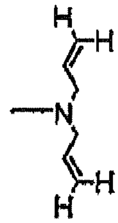

(In the formulae, $R^1$ to $R^5$ each independently represent a hydrogen atom or an alkyl group. $Ar^{31}$ represents an aromatic hydrocarbon ring group which may have a substituent or an aromatic heterocyclic group which may have a substituent.)

Preferred of these, from the standpoints of high reactivity and ease of insolubilization, are cyclic ether groups such as an epoxy group and an oxetane group and groups which undergoes an insolubilization reaction through cationic polymerization, such as a vinyl ether group. Especially preferred of these is an oxetane group from the standpoint that it is easy to control the rate of the cationic polymerization. Meanwhile, a vinyl ether group is especially preferred from the standpoint that this crosslinkable group, during the cationic polymerization, is less apt to form a hydroxyl group, which may cause element deterioration.

Especially preferred, from the standpoint of imparting high electrochemical stability to the hole transport layer, are groups capable of cyclization/addition reaction, such as arylvinylcarbonyl groups, e.g., cinnamoyl, and groups derived from a benzocyclobutene ring. From the standpoint of imparting high stability to the insolubilized structure, groups derived from a benzocyclobutene ring are most preferred.

Specifically, the benzocyclobutene ring-derived groups represented by the following formula (XII) are preferred as the crosslinkable group.

[Chem. 8]

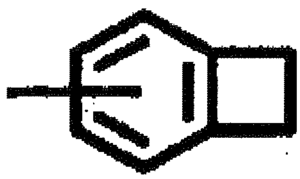
(XII)

[The benzocyclobutene ring of formula (XII) may have substituents. The substituents may have been bonded to each other to form a ring.]

It is preferred that the molecular weight of the hole-transporting compound having a partial structure represented by formula (5) according to the invention should be low from the standpoints that this compound is easy to synthesize and purify and that high-molecular impurities are less apt to be generated. Meanwhile, it is preferred that the molecular weight of the hole-transporting compound having a partial structure represented by formula (5) according to the invention should be high from the standpoint that this compound is high in glass transition temperature, melting point, and vaporization temperature and is excellent in terms of heat resistance and film-forming properties.

Specifically, the molecular weight of the hole-transporting compound having a partial structure represented by formula (5) according to the invention is usually preferably 300 or higher, more preferably 500 or higher, even more preferably 1,000 or higher.

Meanwhile, the weight-average molecular weight of the hole-transporting compound having a partial structure

represented by formula (5) according to the invention is usually preferably 3,000,000 or less, more preferably 1,000,000 or less, even more preferably 500,000 or less, especially preferably 200,000 or less.

The number-average molecular weight of the hole-transporting compound having a partial structure represented by formula (5) according to the invention is usually preferably 2,500,000 or less, more preferably 750,000 or less, even more preferably 400,000 or less.

The hole-transporting compound having a partial structure represented by formula (5) according to the invention may be a low-molecular compound or a high-molecular compound. The term "high-molecular compound" in the invention means a compound represented by a structural formula which contains a plurality of divalent repeating units. The term "low-molecular compound" in the invention means a compound which is not a high-molecular compound.

<Low-molecular Compound>

In the case where the hole-transporting compound having a partial structure represented by formula (5) according to the invention is a low-molecular compound, the molecular weight of this compound is usually preferably 20,000 or less, more preferably 10,000 or less, even more preferably 5,000 or less.

[Formula (XIII)]

[Chem. 9]

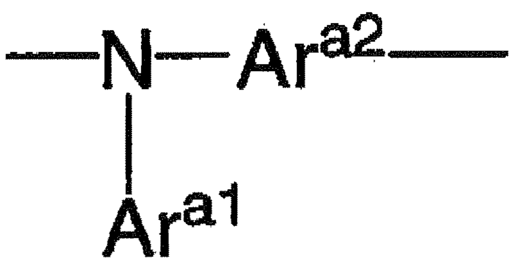

(XIII)

In the case where the hole-transporting compound having a partial structure represented by formula (5) according to the invention is a low-molecular compound, it is preferred that the compound should have a partial structure represented by formula (XIII), because this compound is apt to release an electron upon application of a low voltage thereto to form a radical cation.

[In formula (XIII), $Ar^{a1}$ and $Ar^{a2}$ each independently represent an aromatic group which may have a substituent. However, when $Ar^{a2}$ is located at an end, this $Ar^{a2}$ is substituted with a hydrogen atom at one of the linking sites.]

In formula (XIII), $Ar^{a1}$ and $Ar^{a2}$ each independently represent an aromatic group which may have a substituent. $Ar^{a1}$ and $Ar^{a2}$ may be the same or different. When $Ar^{a2}$ is located at an end, this $Ar^{a2}$ is substituted with a hydrogen atom at one of the linking sites.

The preferred ranges, etc. of the aromatic groups which may have a substituent and are represented by $Ar^{a1}$ and $Ar^{a2}$ are the same as those described above under the section [$Ar^{11}$ to $Ar^{15}$].

In the case where the hole-transporting compound containing a partial structure represented by formula (5) further has a partial structure represented by formula (III), the partial structure represented by formula (XIII) in this compound may be located in any position within formula (5).

Specifically, in the case where $Ar^{a1}$ corresponds to $Ar^{13}$, examples of the structure include: the case where $Ar^{a2}$ corresponds to $Ar^{11}$; the case where p=0 and $Ar^{a2}$ corresponds to $Ar^{14}$; the case where p=m=0 and $Ar^{a2}$ corresponds to $Ar^{12}$; the case where $Ar^{11}$ is a direct bond and $Ar^{a2}$ is an aromatic group directly bonded to the $Ar^{11}$-side end of the partial structure represented by formula (5); and the case where $Ar^{12}$ is a direct bond, p=m=q=0, and $Ar^{a2}$ is an aromatic group directly bonded to the Z-side end of the partial structure represented by formula (5).

Meanwhile, in the case where $Ar^{a1}$ corresponds to $Ar^{15}$, examples of the structure include: the case where $Ar^{a2}$ corresponds to $Ar^{14}$; the case where $Ar^{a2}$ corresponds to $Ar^{12}$; and the case where q=0 and $Ar^{a2}$ is an aromatic group directly bonded to the Z-side end of the partial structure represented by formula (5). Furthermore, there also are cases where the hole-transporting compound containing a partial structure represented by formula (5) has, besides the partial structure of formula (5), a partial structure represented by formula (XIII).

[Formula (XIV)]

[Chem. 10]

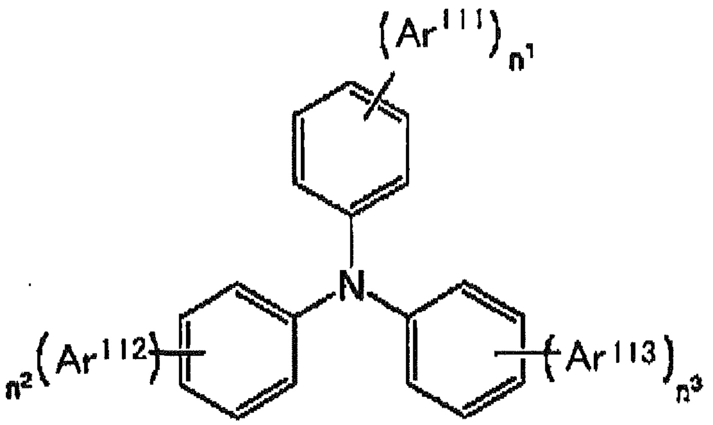

(X I V)

In the case where the hole-transporting compound having a partial structure represented by formula (5) according to the invention is a low-molecular compound, it is preferred that the compound should have a partial structure represented by the following formula (XIV), because the radical cation formed from this compound upon voltage application is stabilized by resonance and this is apt to result in improvements in resistance to oxidation/reduction and hole transport properties.

(In the formula, $Ar^{111}$ to $Ar^{113}$ each independently represent an aromatic group which may have a substituent, and $n^1$ to $n^3$ each independently represent an integer of 0-5. However, when any of $Ar^{111}$ to $Ar^{113}$ is located at an end, this group is substituted with a hydrogen atom at one of the linking sites.)

($Ar^{111}$ to $Ar^{113}$)

In formula (XIV), $Ar^{111}$ to $Ar^{113}$ each independently represent an aromatic group which may have a substituent. $Ar^{111}$ to $Ar^{113}$ may be the same or different. In the case where any of $Ar^{111}$ to $Ar^{113}$ is located at an end, this group is substituted with a hydrogen atom at one of the linking sites. The preferred ranges, etc. of the aromatic groups which may have a substituent and are represented by $Ar^{111}$ to $Ar^{113}$ are the same as those described above under the section [$Ar^{11}$ to $Ar^{15}$].

($n^1$ to $n^3$)

Symbols $n^1$ to $n^3$ each independently represent an integer of 0-5. It is preferred that $n^1$ to $n^3$ each should be 1 or larger. Meanwhile, it is preferred that $n^1$ to $n^3$ each should be 3 or less. So long as $n^1$ to $n^3$ are within that range, steric hindrance is less apt to occur, resulting in high electrical stability. That range hence is preferred.

In the case where the hole-transporting compound containing a partial structure represented by formula (5) further has a partial structure represented by formula (XIV), the partial structure represented by formula (XIV) in this compound may be located in any position within formula (5).

Specifically, in the case, for example, where p, m, and q in formula (5) are 0, examples of the structure include the case where $Ar^{111}$ to $Ar^{113}$ respectively correspond to $Ar^{11}$ to $Ar^{13}$. In the case where p=q=0, examples of the structure include: the case where $Ar^{111}$ to $Ar^{113}$ respectively correspond to $Ar^{12}$, $Ar^{15}$, and $Ar^{14}$; and the case where there is a partial structure represented by formula (XIV) besides the partial structure represented by formula (5).

<High-molecular Compound>

In the invention, the term "high-molecular compound" means a compound represented by a structural formula which contains a plurality of divalent repeating units. Namely, it is preferred that the hole-transporting compound contained in the hole transport layer according to the invention should be a high-molecular compound which contains a partial

structure represented by formula (5). It is more preferred that the hole-transporting compound should be a high-molecular compound which contains a partial structure represented by formula (5) as a repeating unit.

With respect to molecular-weight distribution, the high-molecular compound may be a monodisperse compound (compound in which the number of divalent repeating units is constant) or may have a molecular-weight distribution having a width (compound in which the number of divalent repeating units varies).

In the case where the hole-transporting compound having a partial structure represented by formula (5) according to the invention is a high-molecular compound, the weight-average molecular weight (Mw) of this compound is usually preferably 1,000 or higher, more preferably 2,500 or higher, even more preferably 5,000 or higher, especially preferably 20,000 or higher.

The number-average molecular weight (Mw) of the compound is usually preferably 500 or higher, more preferably 1,500 or higher, even more preferably 3,000 or higher.

The high-molecular compound according to the invention has a dispersity ratio (Mw/Mn) of preferably 3.5 or less, more preferably 2.5 or less, even more preferably 2.0 or less. The smaller the value of dispersity ratio, the more the compound is preferred. Consequently, the lower limit of the dispersity ratio thereof ideally is 1. When the dispersity ratio of the high-molecular compound is within that range, this compound is easy to purify and can be made to have satisfactory solubility in organic solvents and a satisfactory charge-transporting ability.

Usually, the weight-average molecular weight of a high-molecular compound is determined by SEC (size exclusion chromatography). In an SEC measurement, the higher the molecular weight, the shorter the elution time for the component, and the lower the molecular weight, the longer the elution time for the component. In an SEC measurement, the elution times for the sample are converted to a weight-average molecular weight using a calibration curve calculated from the elution times for polystyrene (standard samples) having known weight-average molecular weights.

(Proportion of Crosslinkable Groups)

In the case where the hole-transporting compound contained in the hole transport layer according to the invention has crosslinkable-group-derived groups described above, the number of such crosslinkable-group-derived groups contained in one polymer chain of the compound is preferably 1 or larger on average, more preferably 2 or larger on average. Meanwhile, the number thereof is preferably 200 or less, more preferably 100 or less.

When the number of crosslinkable-group-derived groups possessed by the high-molecular compound according to the invention is expressed in terms of the number thereof per molecular weight of 1,000, then the number thereof is usually preferably 3.0 or less, preferably 2.0 or less, even more preferably 1.0 or less.

Meanwhile, when the number of crosslinkable-group-derived groups possessed by the high-molecular compound according to the invention is expressed in terms of the number thereof per molecular weight of 1,000, then the number thereof is usually preferably 0.01 or larger, more preferably 0.05 or larger.

So long as the number thereof is within that range, the number of crosslinkable groups remaining after a crosslinking reaction is small and the hole transport layer which has undergone the crosslinking reaction has low solubility in solvents, making it easy to form a multilayer structure by a wet film formation method. That range hence is preferred.

The number of crosslinkable-group-derived groups per molecular weight of 1,000 of a high-molecular compound is calculated from the high-molecular compound from which the end groups have been removed and from the ratio among the monomers fed for the synthesis and the structural formula. For example, in the case of the high-molecular compound of the following chemical formula, which is contained in the hole transport layer used in Example 1 given later, the number of crosslinkable-group-derived groups per molecular weight of 1,000 thereof is calculated in the following manner.

[Chem. 11]

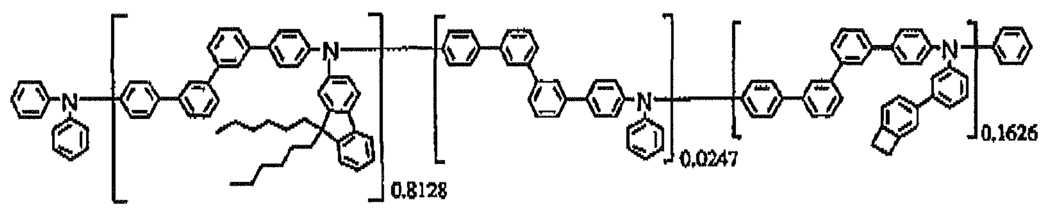

The repeating units of the high-molecular compound of the chemical formula from which the end groups have been removed have a molecular weight of 620.5638 on average, and the number of crosslinkable groups per repeating

unit is 0.1626 on average. These numbers are simply subjected to a proportional calculation. As a result, the number of crosslinkable-group-derived groups per molecular weight of 1,000 is calculated at 0.262.

(Proportion of Dissociable Groups)

In the case where the hole-transporting compound contained in the hole transport layer according to the invention has dissociable-group-derived groups described above, it is preferred that the number of such dissociable-group-derived groups per polymer chain contained in the hole transport layer should be large. Specifically, the number thereof is preferably 5 or larger on average, more preferably 10 or larger on average, especially preferably 50 or larger on average.

When the number of dissociable-group-derived groups possessed by the high-molecular compound according to the invention is expressed in terms of the number thereof per molecular weight of 1,000, then the number thereof is usually preferably 10 or less, more preferably 5 or less. Meanwhile when the number of dissociable-group-derived groups possessed by the high-molecular compound according to the invention is expressed in terms of the number thereof per molecular weight of 1,000, then the number thereof is usually preferably 0.01 or larger, more preferably 0.1 or larger, even more preferably 0.2 or larger.

So long as the number thereof is within that range, a moderate difference in solubility between before and after a dissociation reaction is obtained. That range hence is preferred.

The number of dissociable-group-derived groups per molecular weight of 1,000 of a high-molecular compound is determined in the same manner as the method for calculating the proportion of Crosslinkable groups described above.

(Specific Examples)

Preferred specific examples of the hole-transporting compound having a partial structure represented by formula (5) according to the invention and preferred specific examples of starting materials therefor are shown below. However, the invention should not be construed as being limited to the following examples.

[Chem. 12]

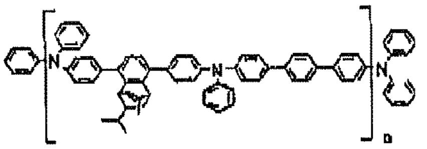

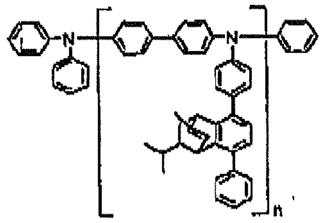

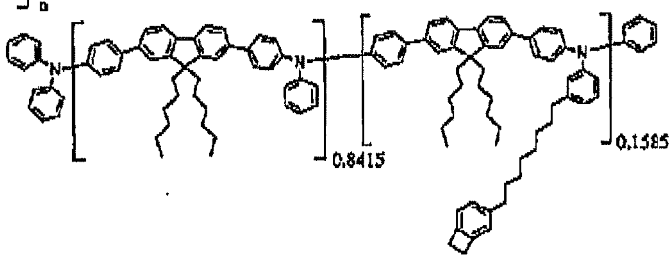

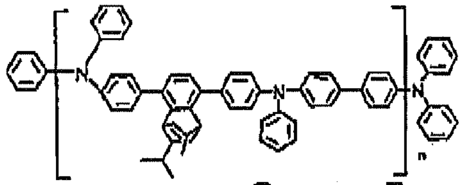

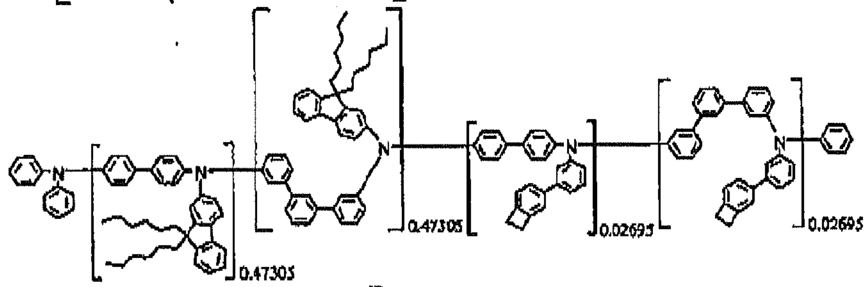

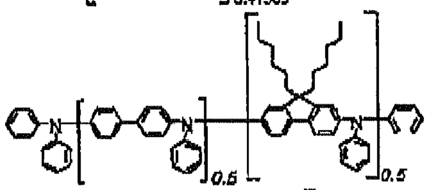

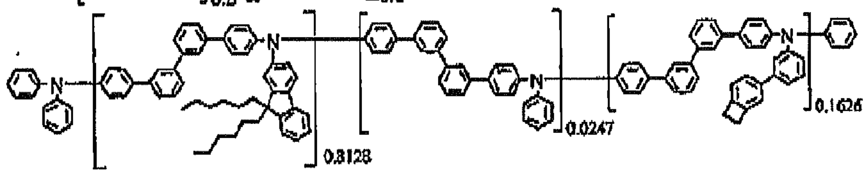

[Chem. 13]

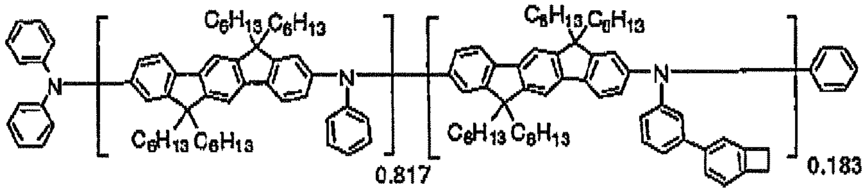

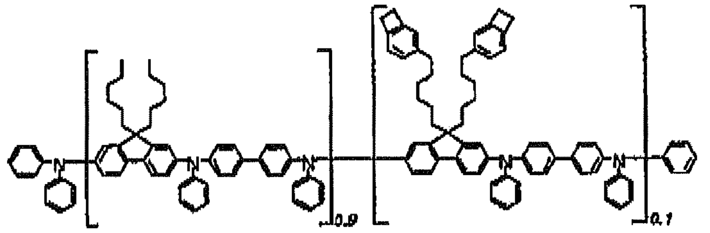

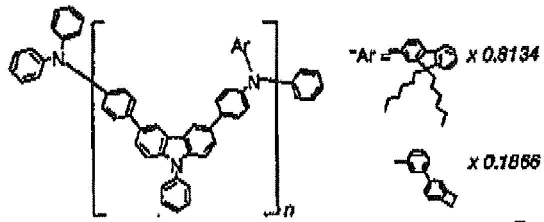

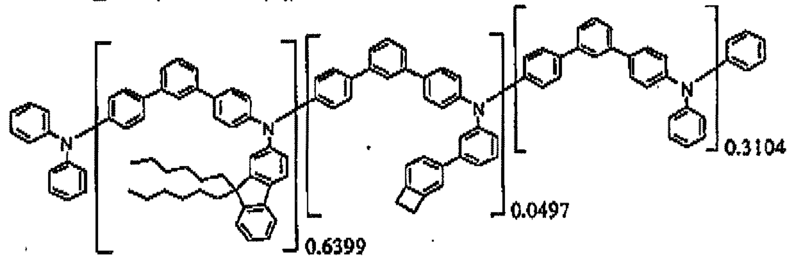

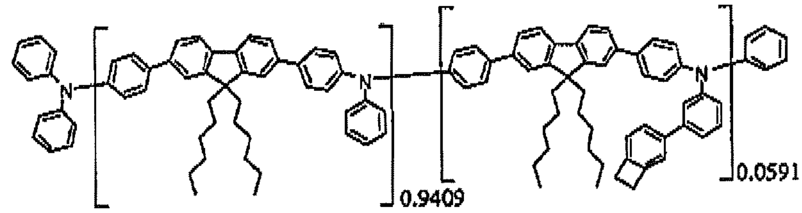

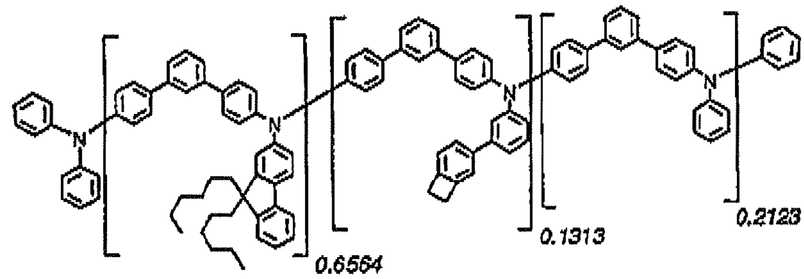

[Chem. 14]

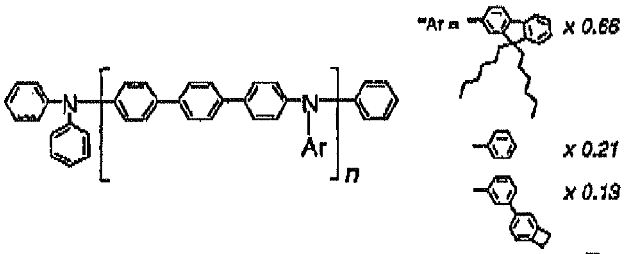

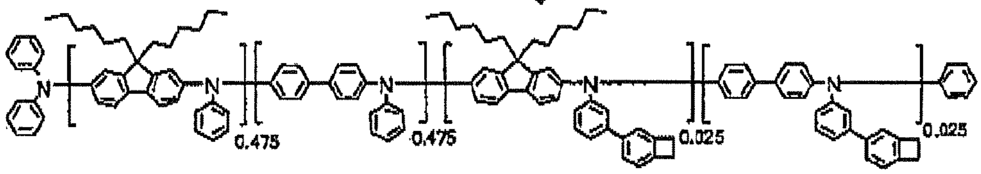

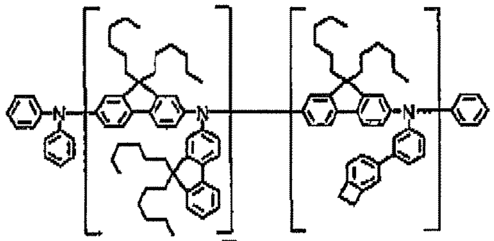

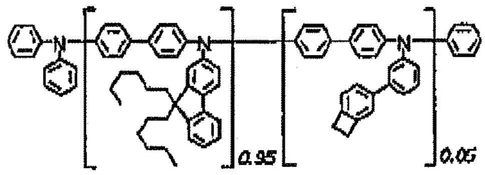

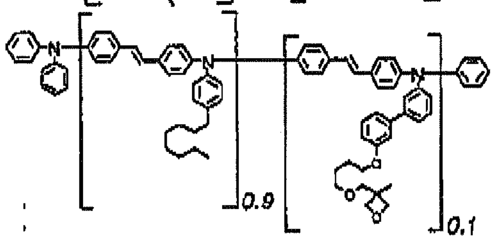

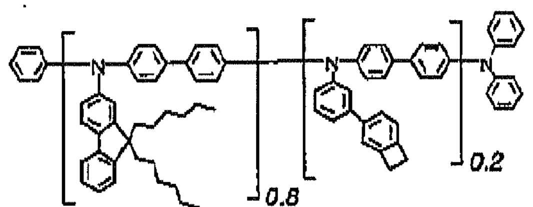

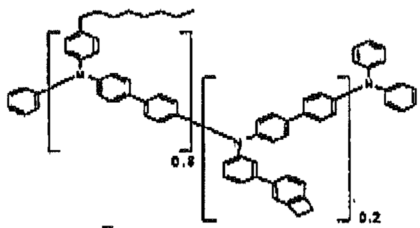

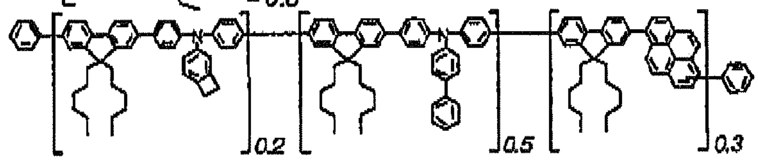

[Chem. 15]

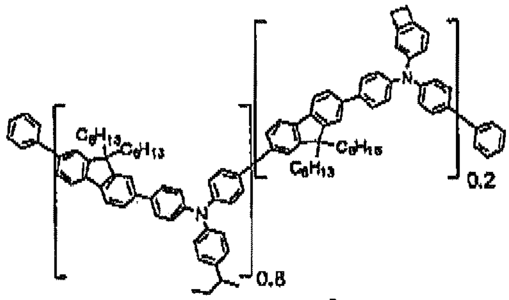

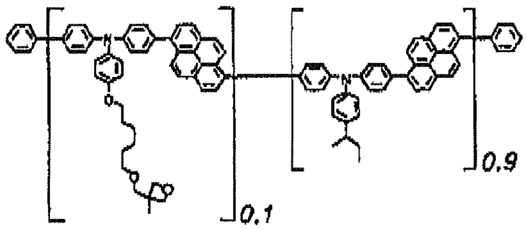

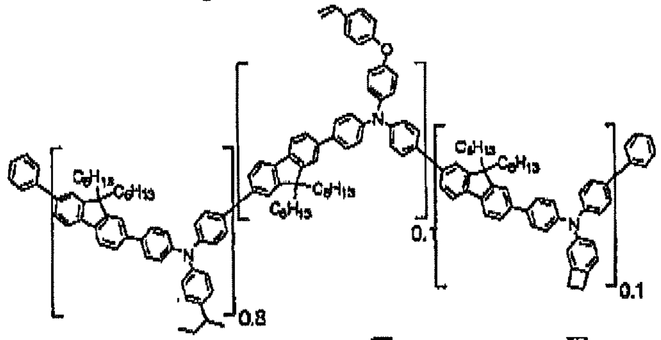

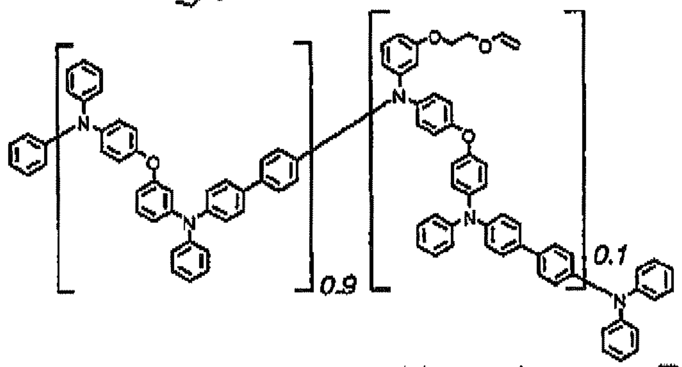

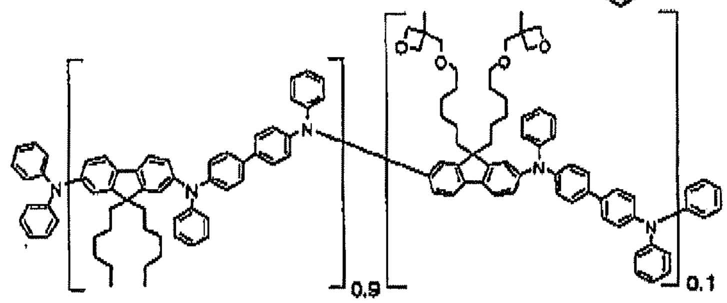

[Chem. 16]

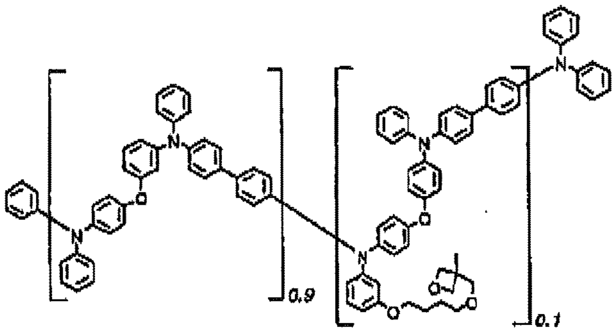

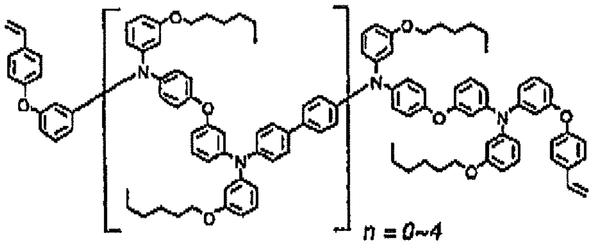

n = 0~4

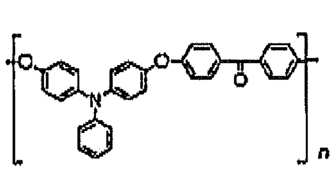

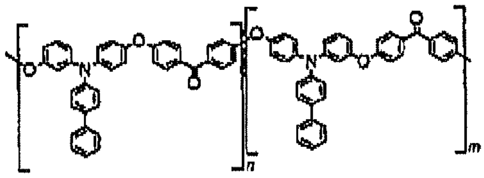

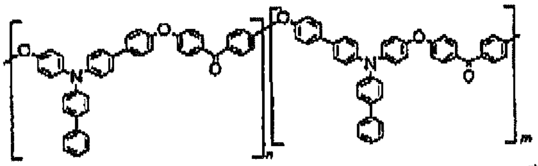

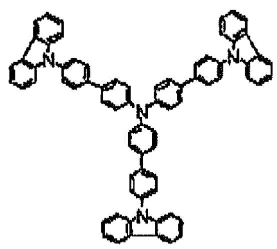

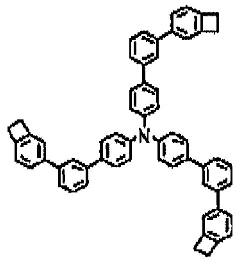

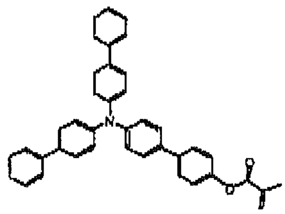

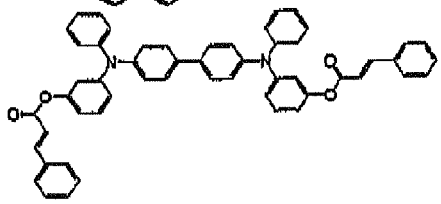

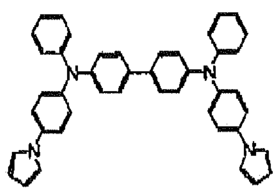

[Chem. 17]

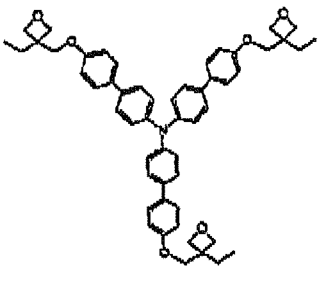
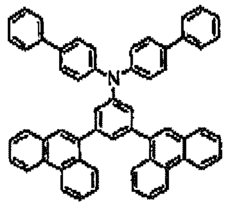
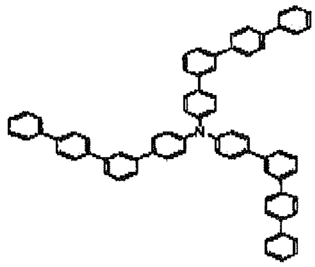
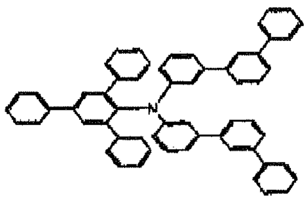
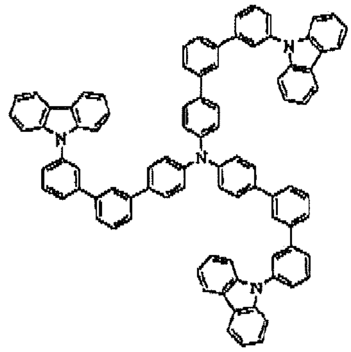
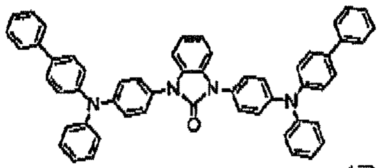
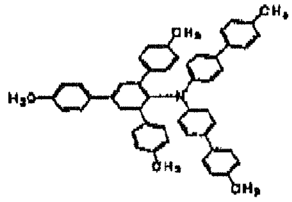
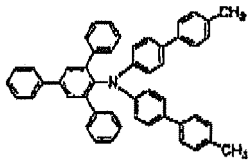
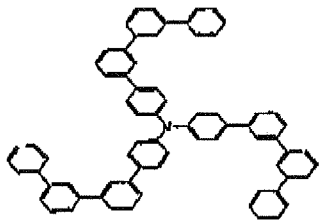
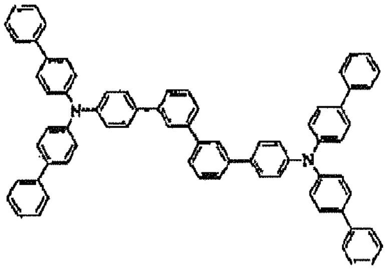
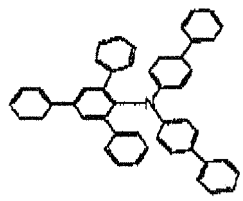
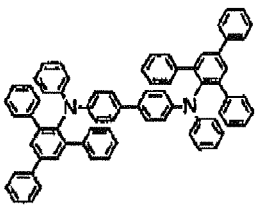
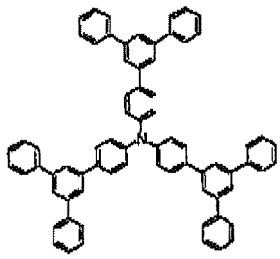
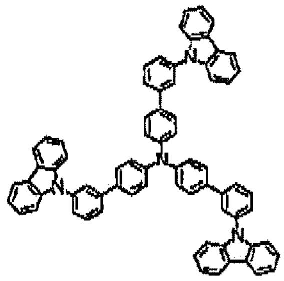

[Chem. 18]

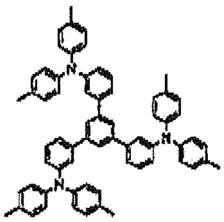
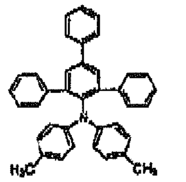
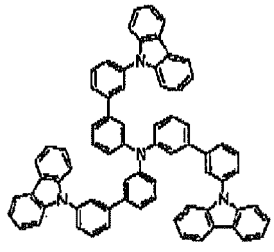
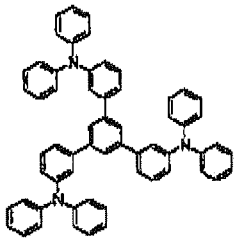
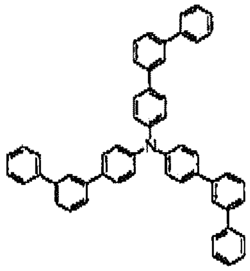
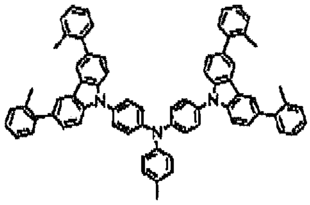
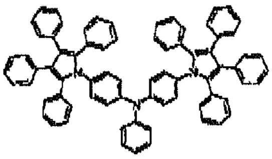

(Other Hole-transporting Compounds)

Hole-transporting compounds other than the hole-transporting compound containing a partial structure represented by formula (5) may be contained in the hole transport layer according to the invention.

(Other Ingredients)

The hole transport layer in the invention may contain ingredients other than the hole-transporting compound. Examples of the other ingredients include an electron-accepting compound.

[Methods for Film Formation]

Methods for forming the hole transport layer according to the invention are not particularly limited unless the effects of the invention are lessened. For forming the hole transport layer according to the invention, either a wet film formation method or a vacuum deposition method may be used.

(Formation of Hole Transport Layer by Wet Film Formation Method)

Examples of the wet film formation method include a method in which a solution of a starting-material composition for a hole transport layer (composition for hole transport layer formation) is applied by a wet process such as, for example, spin coating, dip coating, die coating, bar coating, blade coating, roll coating, spray coating, capillary coating, ink-jet printing, nozzle printing, screen printing, gravure printing, flexographic printing, etc., and the resultant coating film is dried to form a film.

Preferred of those film formation techniques are spin coating, spray coating, ink-jet printing, and nozzle printing. This is because the liquid nature of the composition for hole transport layer formation according to the invention is suitable for these techniques.

In the case where a hole transport layer is formed by a wet film formation method, a composition (composition for hole transport layer formation) which contains materials for constituting the hole transport layer (including the hole-transporting compound) and further contains a solvent is applied by a wet process. Thereafter, the resultant coating film is dried to form a film.

The solvent to be contained in the composition for hole transport layer formation according to the invention is not particularly limited. However, solvents in which the hole-transporting compound according to the invention and other ingredients are highly soluble are preferred. Examples thereof include the following organic solvents: aromatic hydrocarbon solvents such as toluene, xylene, metysilene, tetralin, n-octylbenzene, 1-methylnaphthalene, cyclohexylbenzene, 3-isopropylbiphenyl, 3-methylbiphenyl, and 4-methylbiphenyl; halogen-containing organic solvents such as 1,2-dichloroethane, chlorobenzene, and o-dichlorobenzene; organic ether solvents including aliphatic ethers such as ethylene glycol dimethyl ether, ethylene glycol diethyl ether, and propylene glycol 1-monomethyl ether acetate (PGMEA) and aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole, and 2,4-dimethylanisole; and aliphatic esters such as ethyl acetate,

n-butyl acetate, ethyl lactate, and n-butyl lactate and organic ester solvents such as phenyl acetate, phenyl propionate, methyl benzoate, ethyl benzoate, isopropyl benzoate, propyl benzoate, and n-butyl benzoate. Aromatic hydrocarbon solvents are preferred of those organic solvents from the standpoint that even when such an organic solvent remains in the organic electroluminescent element, the residual solvent is less apt to affect the properties thereof. One of the solvents may be used alone, or any desired combination of two or more thereof may be used in any desired proportion.

The amount of the organic solvent to be contained in the composition for hole transport layer formation is usually preferably 10% by weight or more, more preferably 50% by weight or more, even more preferably 80% by weight or more.

(Formation of Hole Transport Layer by Vacuum Deposition Method)

In the case where a hole transport layer is to be formed by a vacuum deposition method, the following procedure, for example, is used. One or more constituent starting materials (e.g., the hole-transporting compound and an electron-accepting compound) for the hole transport layer are placed in one or more crucibles disposed within a vacuum vessel (when two or more materials are used, the materials are placed in respective crucibles). The inside of the vacuum vessel is evacuated with an appropriate vacuum pump to about $10^{-4}$ Pa, and the crucibles are then heated (when two or more materials are used, the respective crucibles are heated) to vaporize the materials while controlling vaporization amount (when two or more materials are used, the materials are vaporized while independently controlling the amounts of the materials being vaporized) to thereby form a hole transport layer on the anode of a substrate placed so as to face the crucibles. Incidentally, in the case where two or more materials are used, use may be made of a method in which a mixture of these materials is placed in a crucible, heated, and vaporized to form a hole transport layer.

The degree of vacuum during the deposition is not limited unless the effects of the invention are considerably lessened. However, it is usually preferred that the degree of vacuum should be $0.1\times10^{-6}$ Torr ($0.13\times10^{-4}$ Pa) or higher and $9.0\times10^{-6}$ Torr ($12.0\times10^{-4}$ Pa) or less.

The rate of deposition is not limited unless the effects of the invention are considerably lessened. However, it is usually preferred that the rate of deposition should be 0.1 Å/sec or higher and be 15.0 Å/sec or less.

Film formation temperature during the deposition is not limited unless the effects of the invention are considerably lessened. However, it is preferred that the temperature should be 10°C or higher and be 50°C or lower.

[Luminescent Layer]

The luminescent layer is a layer which lies between the hole transport layer and the cathode, and is a layer which luminesces upon excitation when an electric field is applied to between the anode and the cathode and holes thus injected from the anode recombine with electrons thus injected from the cathode. The luminescent layer in the invention contains both a luminescent material and a charge transport material.

(Luminescent Material)

The luminescent material is not particularly limited, and materials which are in use as luminescent materials for organic electroluminescent elements can usually be employed.

The luminescent material may be a fluorescent material or a phosphorescent material. Fluorescent materials have a smaller energy gap in an excited singlet state than phosphorescent materials having the same luminescence wavelength, and have an exceedingly short exciton life on the order of nanosecond. Consequently, a smaller load is imposed on the luminescent materials, and elements employing the materials are apt to have a longer working life. On the other hand, phosphorescent materials, theoretically, impart an exceedingly high luminescent efficiency to the organic electroluminescent element as compared with phosphorescent materials. It is therefore preferred to use a fluorescent material when working life is especially important.

Meanwhile, when luminescent efficiency is especially important, it is preferred to use a phosphorescent material. It is also possible to use one or more fluorescent materials and one or more phosphorescent materials in combination. For example, a blue fluorescent material and green and red phosphorescent materials are used.

It is preferred to use a luminescent material which is low in molecular symmetry and stiffness or a luminescent material into which an oleophilic substituent, e.g., an alkyl group, has been introduced, from the standpoint that these materials have high solubility in organic solvents.

Representative examples of the fluorescent material are explained below. However, the fluorescent material should not be construed as being limited to the following representative examples.

Examples of fluorescent materials which give blue luminescence (blue fluorescent colorants) include naphthalene, chrysene, perylene, pyrene, anthracene, coumarin, p-bis(2-phenylethenyl)benzene, arylamines, and derivatives of these. Preferred of these are anthracene, chrysene, pyrene, arylamines, derivatives of these, and the like.

Examples of fluorescent materials which give green luminescence (green fluorescent colorants) include

quinacridone, coumarin, aluminum complexes such as $Al(C_9H_6NO)_3$, and derivatives of these.

Examples of fluorescent materials which give yellow luminescence (yellow fluorescent colorants) include rubrene, perimidone, and derivatives of these.

Examples of fluorescent materials which give red luminescence (red fluorescent colorants) include DCM (4-(dicyanomethylene)-2-methyl-6-(p-dimethylaminostyrene)-4H-pyran) type compounds, benzopyran, Rhodamine, xanthenes such as benzothioxanthene and azabenzothioxanthene, and derivatives of these.

The arylamine derivatives shown above as fluorescent materials more specifically include compounds represented by the following formula (II), which are especially preferred from the standpoints of the luminescent efficiency and working life of the element, etc.

[Chem. 19]

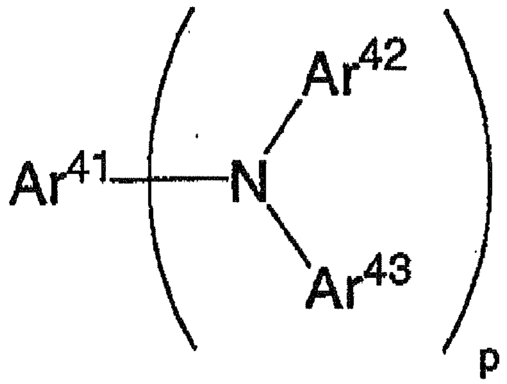

(II)

(In the formula, $Ar^{41}$ represents a substituted or unsubstituted fused aromatic group having 10-40 nuclear carbon atoms, and $Ar^{42}$ and $Ar^{43}$ each independently represent a substituted or unsubstituted, monovalent aromatic group having 6-40 carbon atoms. Symbol p represents an integer of 1-4.)

Specific examples of $Ar^{41}$ include residues of naphthalene, phenanthrene, fluoranthene, anthracene, pyrene, perylene, coronene, chrysene, picene, diphenylanthracene, fluorene, triphenylene, rubicene, benzanthracene, phenylanthracene, bisanthracene, dianthracenylbenzene, and dibenzanthracene.

Preferred examples of the arylamine derivatives as fluorescent materials are shown below. In the following, "Me" represents a methyl group and "Et" represents an ethyl group.

[Chem. 20]

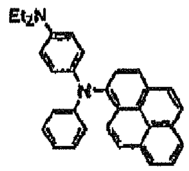
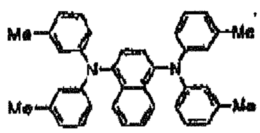

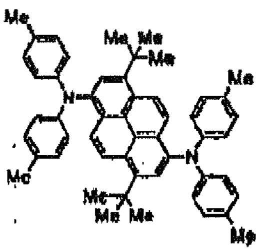
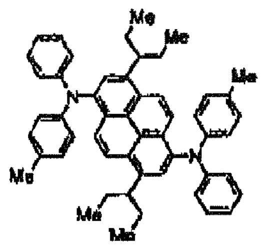
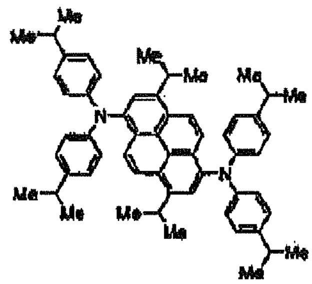

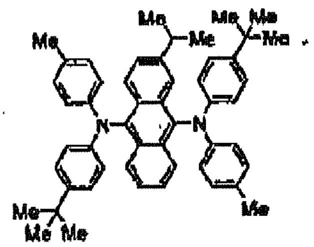
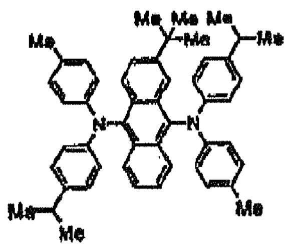
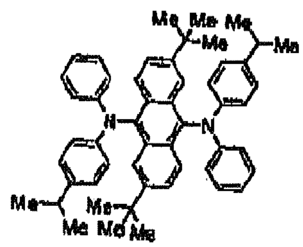

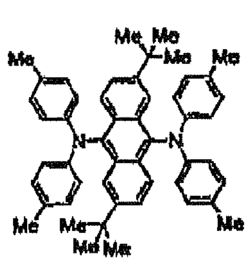
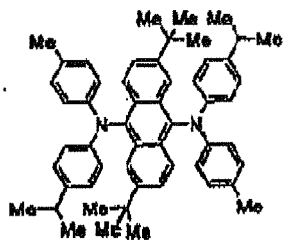
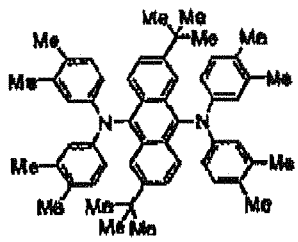

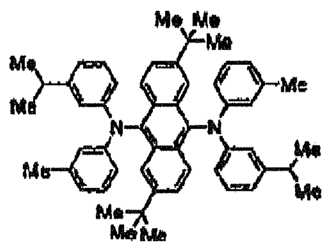
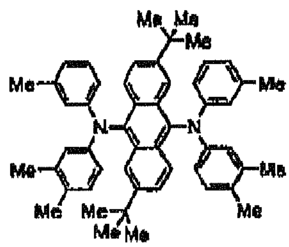

[Chem. 21]

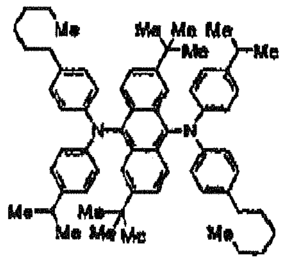
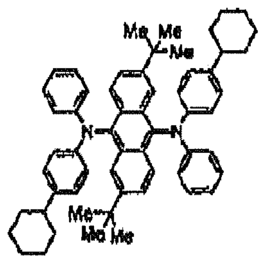
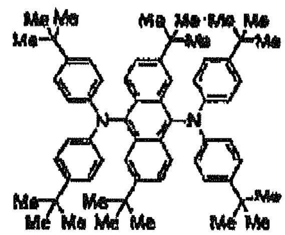

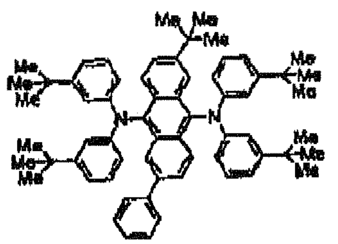
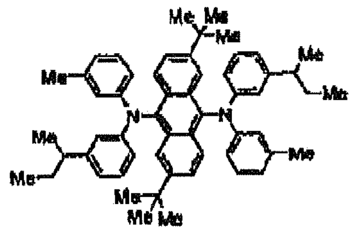

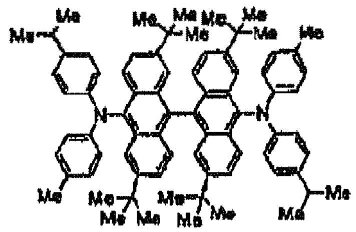
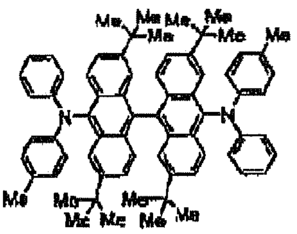

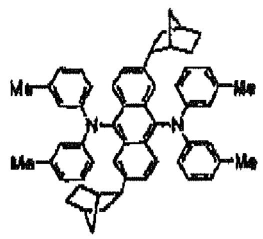
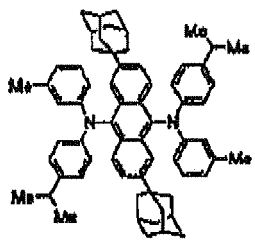
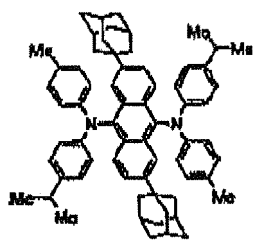

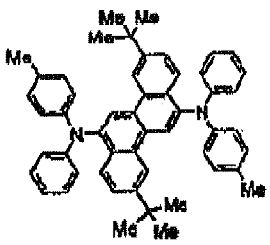
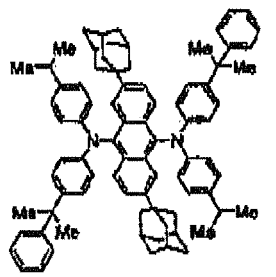

[Chem. 22]

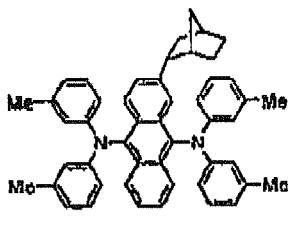

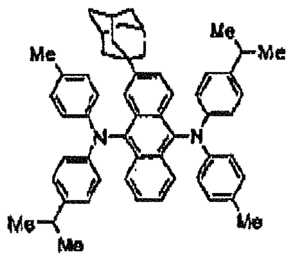

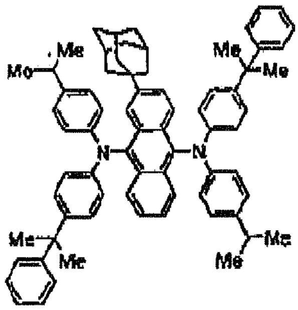

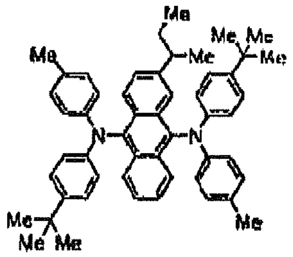

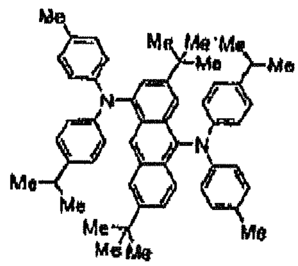

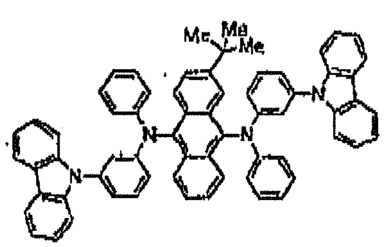

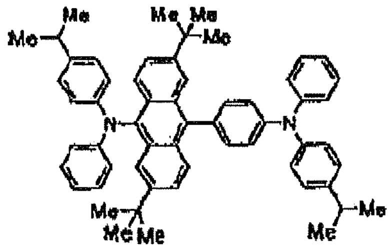

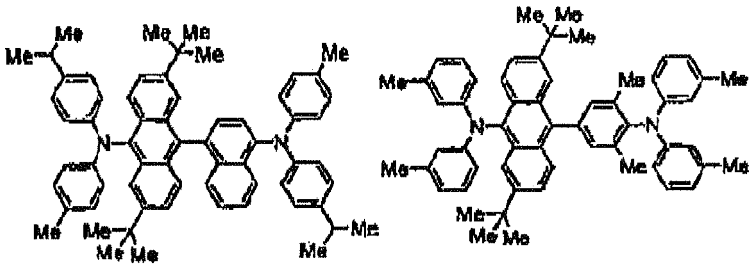

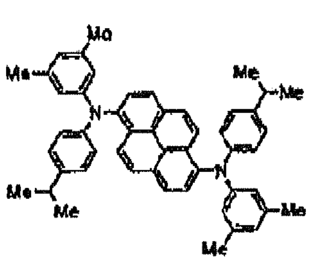

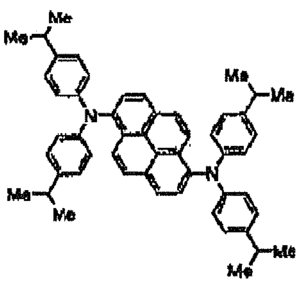

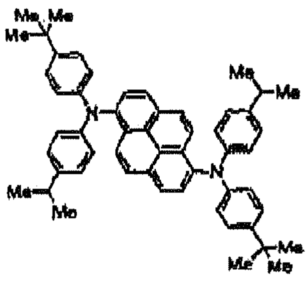

[Chem. 23]

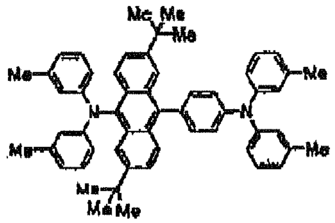
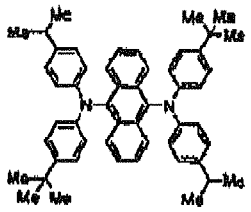
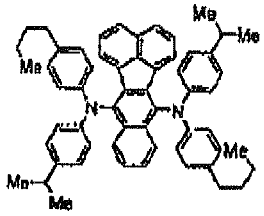
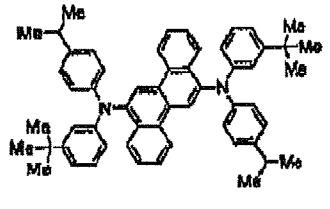
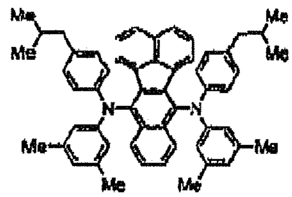
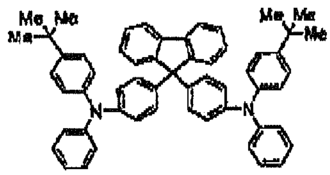
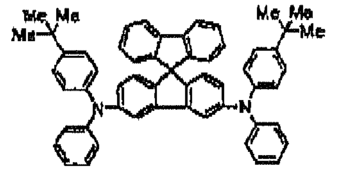
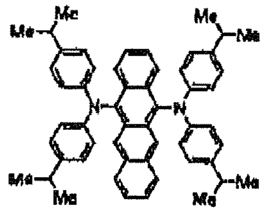
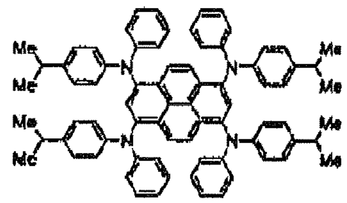
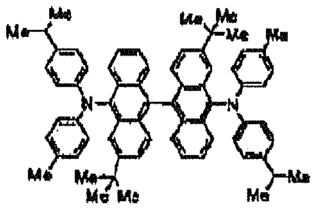
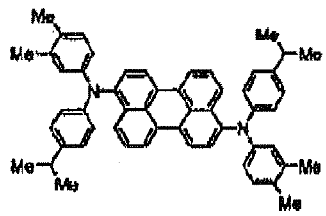
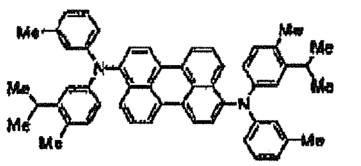

Representative examples of the phosphorescent material are explained below. However, the phosphorescent material should not be construed as being limited to the following representative examples. Examples of the phosphorescent material include Werner complexes and organometallic complexes which contain a metal selected from Groups 7 to 11 of the long-form periodic table (hereinafter, the expression "periodic table" means the long-form periodic table unless otherwise indicated) as the central metal.

Preferred examples of the metal selected from Groups 7 to 11 of the periodic table are ruthenium, rhodium, palladium, silver, rhenium, osmium, iridium, platinum, gold, and the like, More preferred are iridium and platinum.

Preferred ligands of the complexes are ligands constituted of a (hetero)aryl group and pyridine, pyrazole, phenanthroline, or the like linked to the group, such as a (hetero)arylpyridine ligand and a (hetero)arylpyrazole ligand. More preferred are a phenylpyridine ligand, a phenylpyrazole ligand, and the like. The term "(hetero)aryl" herein means an aryl group or a heteroaryl group.

Specific examples of the phosphorescent material include tris(2-phenylpyridine)iridium, tris(2-phenylpyridine) ruthenium, tris(2-phenylpyridine)palladium, bis(2-phenylpyridine)platinum, tris(2-phenylpyridine)osmium, tris(2-phenylpyridine)rhenium, octaethylplatinum porphyrin, octaphenylplatinum porphyrin, octaethylpalladium porphyrin, and octaphenylpalladium porphyrin.
In particular, preferred examples of phosphorescent organometallic complexes as phosphorescent materials include compounds represented by the following formula (III) or formula (IV).
$ML_{(q-j)}L'_j$ (III)

[In formula (III), M represents a metal, and q indicates the valence of the metal. L and L' represent bidentate ligands. Symbol j represents a number of 0, 1, or 2.]
[Chem. 24]

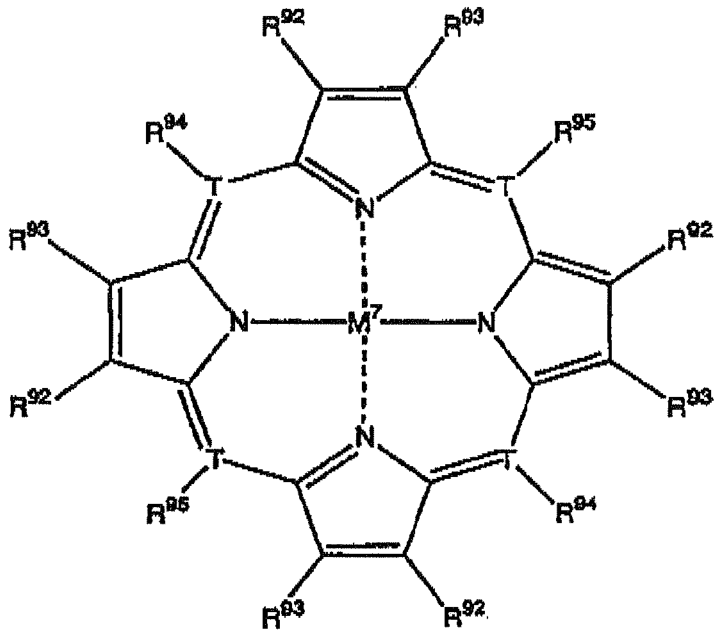

(IV)

[In formula (IV), $M^7$ represents a metal, and T represents a carbon atom or a nitrogen atom. $R^{92}$ to $R^{95}$ each independently represent a substituent. However, when T is a nitrogen atom, $R^{94}$ and $R^{95}$ are absent.]
First, the compounds represented by formula (III) are explained below.
In formula (III), M represents any metal. Preferred examples of M include the metals shown above as metals selected from Groups 7 to 11 of the periodic table.
The bidentate ligand L in formula (III') preferably is a ligand which has the following partial structure.
[Chem. 25]

L:

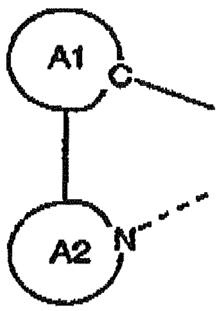

(III')

In the partial structure of L, ring A1 represents an aromatic hydrocarbon ring group or aromatic heterocyclic group which may have a substituent.

Examples of the aromatic hydrocarbon ring group include 5- or 6-membered monocycles or di- to pentacyclic fused rings in which each cycle is 5- or 6-membered. Specific examples thereof include monovalent groups derived from a benzene ring, naphthalene ring, anthracene ring, phenanthrene ring, perylene ring, tetracene ring, pyrene ring, benzpyrene ring, chrysene ring, triphenylene ring, acenaphthene ring, fluoranthene ring, and fluorene ring.

Examples of the aromatic heterocyclic group include 5- or 6-membered monocycles or di- to tetracyclic fused rings in which each cycle is 5- or 6-membered. Specific examples thereof include monovalent groups derived from a furan ring, benzofuran ring, thiophene ring, benzothiophene ring, pyrrole ring, pyrazole ring, imidazole ring, oxadiazole ring, indole ring, carbazole ring, pyrroloimidazole ring, pyrrolopyrazole ring, pyrrolopyrrole ring, thienopyrrole ring, thienothiophene ring, furopyrrole ring, furofuran ring, thienafuran ring, benzoisooxazole ring, benzoisothiazole ring, benzoimidazole ring, pyridine ring, pyrazine ring, pyridazine ring, pyrimidine ring, triazine ring, quinoline ring, isoquinoline ring, cinnoline ring, quinoxaline ring, phenanthridine ring, benzimidazole ring, perimidine ring, quinazoline ring, quinazolinone ring, and azulene ring.

In the partial structure of L, ring A2 represents a nitrogen-containing aromatic heterocyclic group which may have a substituent.

Examples of the nitrogen-containing aromatic heterocyclic group include groups derived from 5- or 6- membered monocycles or di- to tetracyclic fused rings in which each cycle is 5- or 6-membered. Specific examples thereof include monovalent groups derived from a pyrrole ring, pyrazole ring, imidazole ring, oxadiazole ring, indole ring, carbazole ring, pyrroloimidazole ring, pyrrolopyrazole ring, pyrrolopyrrole ring, thienopyrrole ring, furopyrrole ring, thienofuran ring, benzoisooxazole ring, benzoisothiazole ring, benzoimidazole ring, pyridine ring, pyrazine ring, pyridazine ring, pyrimidine ring, triazine ring, quinoline ring, isoquinoline ring, quinoxaline ring, phenanthridine ring, benzimidazole ring, perimidine ring, quinazoline ring, and quinazolinone ring.

Examples of the substituent which may be possessed by each of ring A1 and ring A2 include halogen atoms, alkyl groups, alkenyl groups, alkoxycarbonyl groups, alkoxy groups, aryloxy groups, dialkylamino groups, diarylamino groups, carbazolyl, acyl groups, haloalkyl groups, cyano, and aromatic hydrocarbon ring groups.

The bidentate ligand L' in formula (III) preferably is a ligand which has any of the following partial structures. In the following formulae, "Ph" represents a phenyl group.

[Chem. 26]

L' :

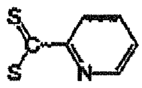
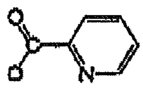
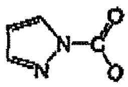
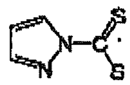
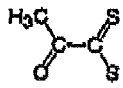
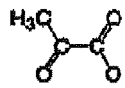

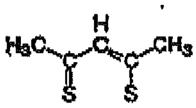
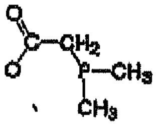
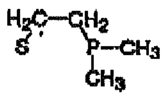
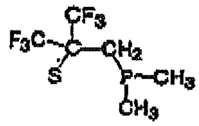
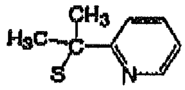

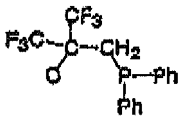
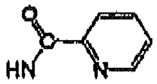
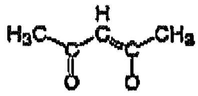
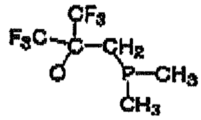
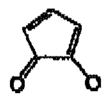

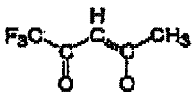
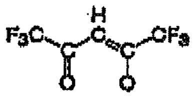
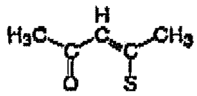
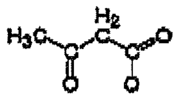

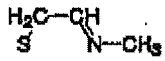
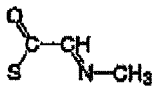
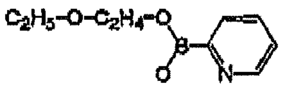
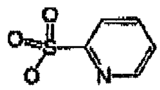
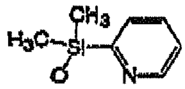

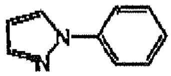
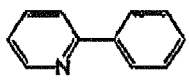
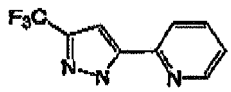
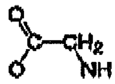

Of these, the following ligands are preferred as L' from the standpoint of the stability of the complex.

[Chem. 27]

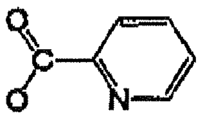
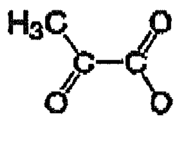
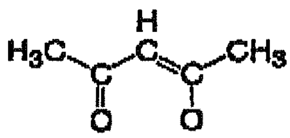

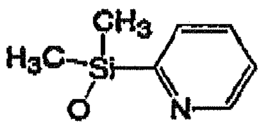
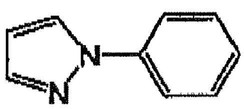
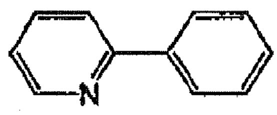

More preferred examples of the compounds represented by formula (III') include compounds represented by the following formulae (IIIa), (IIIb), and (IIIc).

[Chem. 28]

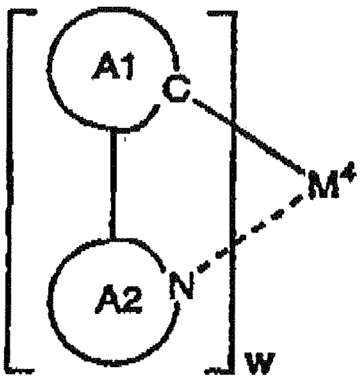

(IIIa)

[In formula (IIIa), $M^4$ represents the same metal as M; w indicates the valence of the metal; ring A1 represents an aromatic hydrocarbon ring group which may have a substituent; and ring A2 represents a nitrogen-containing aromatic heterocyclic group which may have a substituent.]

[Chem. 29]

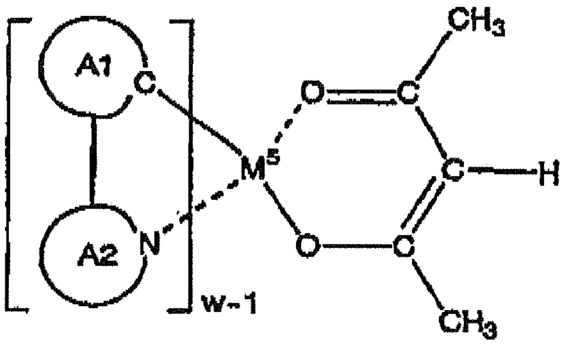

(IIIb)

[In formula (IIIb), $M^5$ represents the same metal as M; w indicates the valence of the metal; ring A1 represents an aromatic hydrocarbon ring group or aromatic heterocyclic group which may have a substituent; and ring A2 represents a nitrogen-containing aromatic heterocyclic group which may have a substituent.]

[Chem. 30]

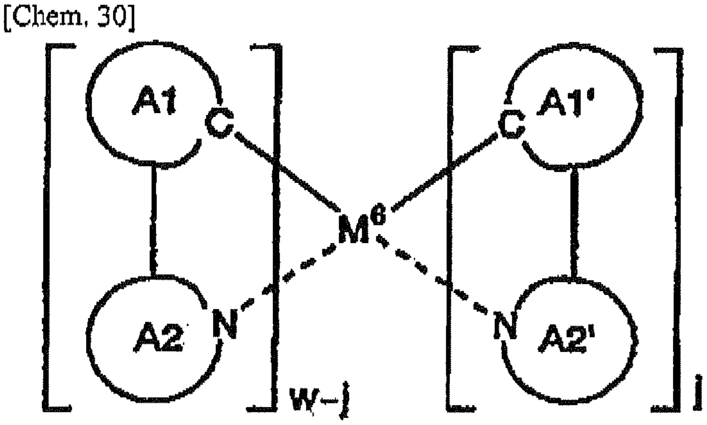

(IIIc)

[In formula (IIIc), $M^6$ represents the same metal as M; w indicates the valence of the metal; j represents 0, 1,

or 2; ring A1 and ring A1' each independently represent an aromatic hydrocarbon ring group or aromatic heterocyclic group which may have a substituent; and ring A2 and ring A2' each independently represent a nitrogen-containing aromatic heterocyclic group which may have a substituent.]

Preferred examples of ring A1 and ring A1' in formulae (IIIa) to (IIIc) include phenyl, biphenyl, naphthyl, anthryl, thienyl, furyl, benzothienyl, benzofuryl, pyridyl, quinolyl, isoquinolyl, and carbazolyl.

Preferred examples of ring A2 and ring A2' in formulae (IIIa) to (IIIc) include pyridyl, pyrimidyl, pyrazyl, triazyl, benzothiazole group, benzoxazole group, benzimidazole group, quinolyl, isoquinolyl, quinoxalyl, and phenanthridyl.

Examples of substituents which may be possessed by the compounds represented by formulae (IIIa) to (IIIc) include halogen atoms, alkyl groups, alkenyl groups, alkoxycarbonyl groups, alkoxy groups, aryloxy groups, dialkylamino groups, diarylamino groups, carbazolyl, acyl groups, haloalkyl groups, and cyano.

These substituents may have been linked to each other to form a ring. For example, a substituent possessed by ring A1 may be bonded to a substituent possessed by ring A2 to thereby form one fused ring, or a substituent possessed by ring A1' may be bonded to a substituent possessed by ring A2' to thereby form one fused ring, Examples of such fused rings include a 7,8-benzoquinoline group.

Preferred of those substituents of ring A1,ring A1', ring A2, and ring A2' are alkyl groups, alkoxy groups, aromatic hydrocarbon ring groups, cyano, halogen atoms, haloalkyl groups, diarylamino groups, and carbazolyl.

Preferred examples of $M^4$ to $M^6$ in formulae (IIIa) to (IIIc) include ruthenium, rhodium, palladium, silver, rhenium, osmium, indium, platinum, and gold.

Specific examples of the organometallic complexes represented by formulae (III) and (IIIa) to (IIIc) are shown below. However, the phosphorescent organometallic complexes should not be construed as being limited to the following compounds.

[Chem. 31]

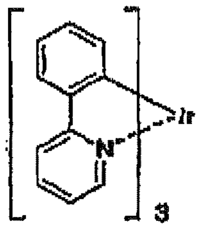 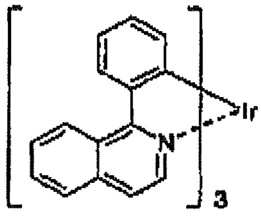 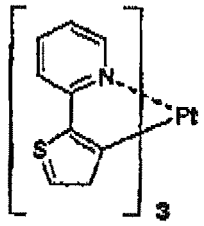

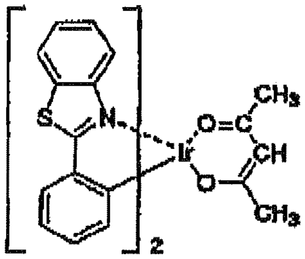 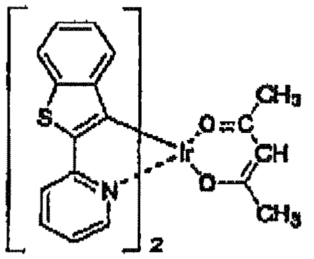 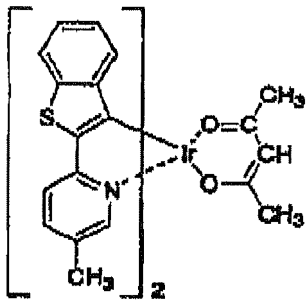

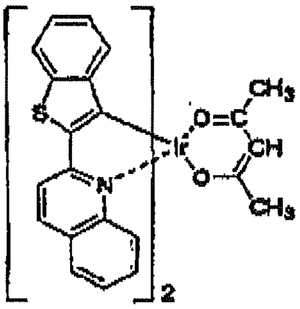 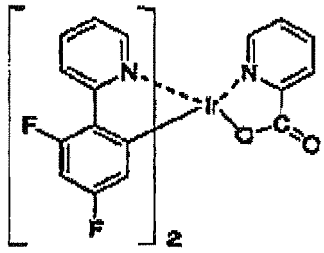 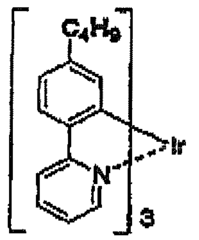

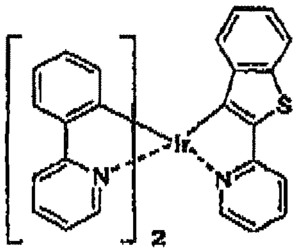 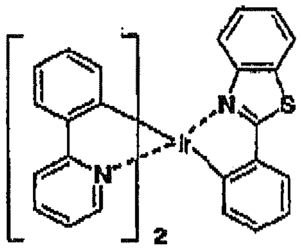 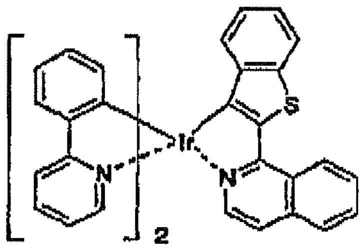

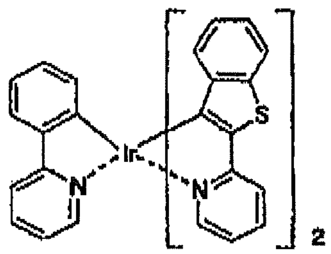 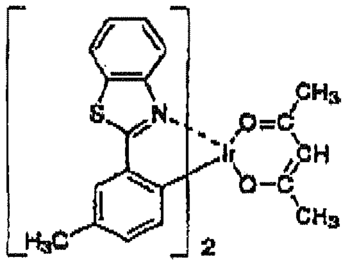 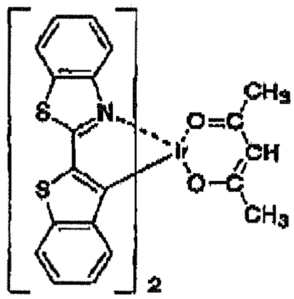

[Chem. 32]

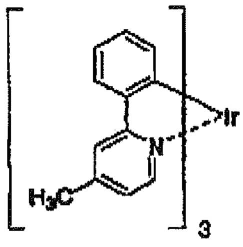
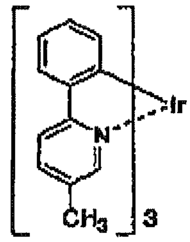
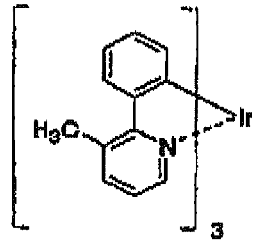
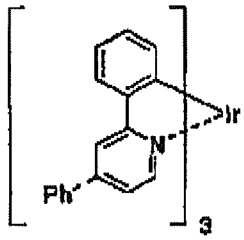
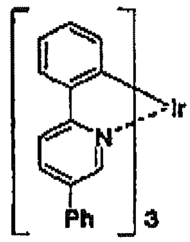
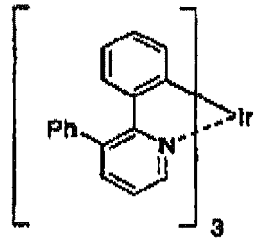
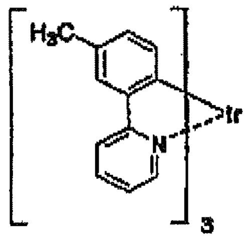
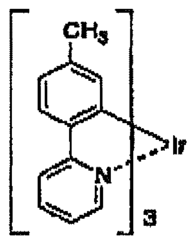
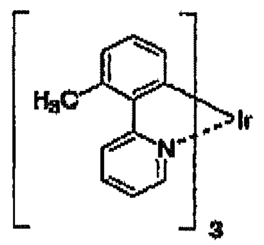
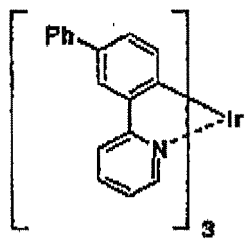
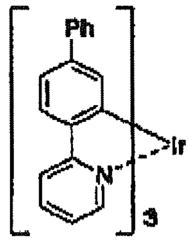
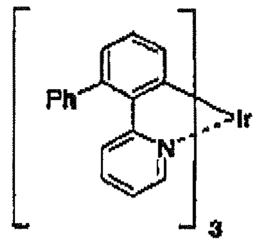
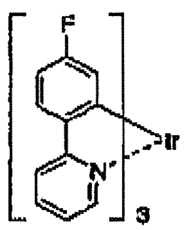
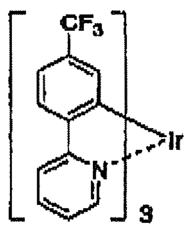
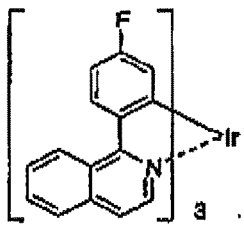
.

Especially preferred of the organometallic complexes represented by formula (III) are compounds which have a 2-arylpyridine-based ligand as the ligand L and/or L'. Namely, compounds having a 2-arylpyridine, a 2-arylpyridine having any substituent(s) bonded thereto, and a group composed of a 2-arylpyridine and any group fused thereto are preferred. Furthermore, the compounds described in International Publication No. 2005/019373 are also usable as luminescent materials.

Next, the compounds represented by formula (IV) are explained.

In formula (IV), $M^7$ represents a metal. Examples thereof include the metals shown above as metals selected from Groups 7 to 11, of the periodic table. Preferred examples, among these, include ruthenium, rhodium, palladium,

silver, rhenium, osmium, iridium, platinum, and gold. Especially preferred examples include divalent metals such as platinum and palladium.

In formula (IV), $R^{92}$ and $R^{93}$ each independently represent a hydrogen atom, a halogen atom, an alkyl group, an aralkyl group, an alkenyl group, cyano, amino, an acyl group, an alkoxycarbonyl group, carboxyl, an alkoxy group, an alkylamino group, an aralkylamino group, a haloalkyl group, hydroxy, an aryloxy group, an aromatic hydrocarbon ring group, or an aromatic heterocyclic group.

Furthermore, when T is a carbon atom, $R^{94}$ and $R^{95}$ each independently represent a substituent, examples of which are the same as the examples of $R^{92}$ and $R^{93}$. When T is a nitrogen atom, $R^{94}$ and $R^{95}$ are absent.

$R^{92}$ to $R^{95}$ may further have substituents. In the case where $R^{92}$ to $R^{95}$ further have substituents, the kinds thereof are not particularly limited and the substituents can be any desired groups.

Any two or more groups among $R^{92}$ to $R^{95}$ may be linked to each other to form a ring.

Specific examples (T-1 and T-10 to T-15) of the organometallic complexes represented by formula (IV) are shown below. However, the organometallic complexes represented by formula (IV) should not be construed as being limited to the following examples. In the following chemical formulae, "Me" represents a methyl group and "Et" represents an ethyl group.

[Chem. 33]

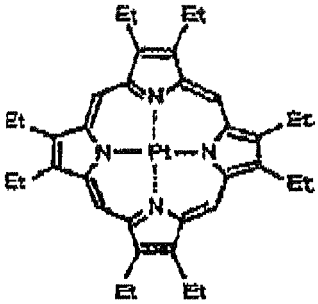

(T-1)

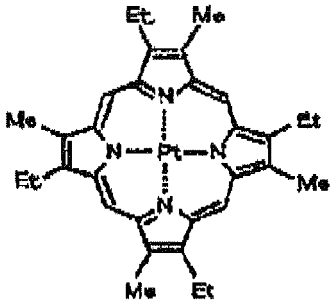

(T-10)

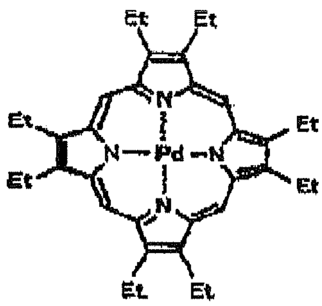

(T-11)

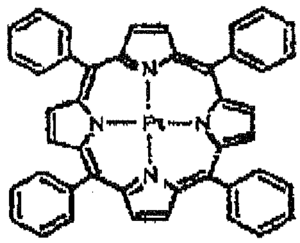

(T-12)

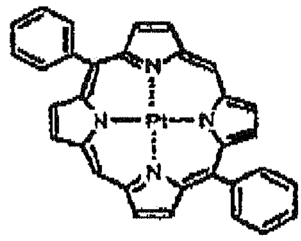

(T-13)

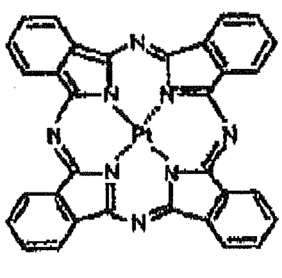

(T-14)

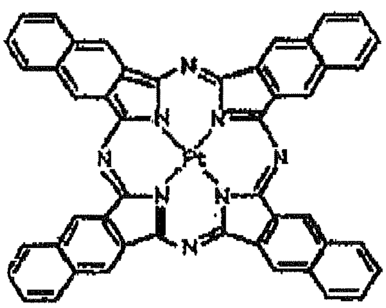

(T-15)

Especially from the standpoint of ease of satisfying expressions (1) to (4) given above, the following luminescent materials are preferred. Specific examples include naphthalene, chrysene, perylene, pyrene, anthracene, coumarin, p-bis(2-phenylethenyl)benzene, arylamines, and derivatives of these.

Preferred of these are: anthracene, chrysene, pyrene, arylamines, and derivatives of these; quinacridone, coumarin, aluminum complexes such as $Al(C_9H_6NO)_3$, and derivatives of these; rubrene, perimidone, and derivatives of these; DCM (4-(dicyanomethylene)-2-methyl-6-(p-dimethylaminostyrene)-4H-pyran) type compounds, benzopyran, Rhodamine, xanthenes such as benzothioxanthene and azabenzothioxanthene, and derivatives of these; and the like.

Also preferred are complexes which include: a metal selected from Groups 7 to 11 of the periodic table, i.e., ruthenium, rhodium, palladium, silver, rhenium, osmium, iridium, platinum, gold, etc.; and a ligand constituted of a (hetero) aryl group and pyridine, pyrazole, phenanthroline, or the like linked to the group, such as a (hetero)arylpyridine ligand and a (hetero)arylpyrazole ligand.

The luminescent material has any desired molecular weight unless the effects of the invention are considerably lessened thereby. However, the molecular weight thereof is usually preferably 10,000 or less, more preferably 5,000 or less, even more preferably 4,000 or less, especially preferably 3,000 or less. Meanwhile, the molecular weight thereof is usually preferably 100 or higher, more preferably 200 or higher, even more preferably 300 or higher, especially preferably 400 or higher,

When the molecular weight of the luminescent material is not lower than the lower limit, this luminescent material has excellent heat resistance, is less apt to arouse troubles such as gas evolution, and gives a luminescent layer which has so stable film quality that the possibility that the organic electroluminescent element might suffer a change in morphology due to migration, etc. is low. Such a molecular weight hence is preferred. On the other hand, when the molecular weight of the luminescent material is not higher than the upper limit, this luminescent material is easy to purify and has excellent solubility in organic solvents. Such a molecular weight hence is preferred.

(Charge Transport Material)

The charge transport material is not particularly limited, and materials which are in use as charge transport materials for organic electroluminescent elements can usually be employed.

It is preferred that in the organic electroluminescent element, the luminescent material should receive charges or energy from a material which has a charge-transporting ability and luminesce thereby. Consequently, the charge transport material according to the invention preferably is a material which is capable of transferring charges or energy to the luminescent material to cause the luminescent material to luminesce. Examples of the charge transport material include compounds having a hole-transporting ability and compounds having an electron-transporting ability.

Preferred as the charge transport material is an aromatic compound which may have a substituent. The aromatic ring compound may be either an aromatic hydrocarbon or an aromatic heterocycle so long as the compound has aromaticity. It is preferred that the charge transport material should have either a structure configured of aromatic hydrocarbon or aromatic heterocyclic rings which have been fused together and may have 2-10 substituents or a structure configured of aromatic hydrocarbon or aromatic heterocyclic rings which have been linked together and may have 3-10 unfused substituents.

Examples of the charge transport material are explained below. However, the charge transport material in the invention should not be construed as being limited to the following examples. Examples of the charge transport material include aromatic amine compounds, phthalocyanine compounds, porphyrin compounds, thiophene compounds, benzylphenyl compounds, fluorene compounds, hydrazone compounds, silazane compounds, silanamine compounds, phosphamine compounds, quinacridone compounds, triphenylene compounds, carbazole compounds, pyrene compounds, anthracene compounds, phenanthroline compounds, quinoline compounds, pyridine compounds, pyrimidine compounds, triazine compounds, oxadiazole compounds, and imidazole compounds.

More specifically, examples thereof include aromatic amine compounds which contain two or more tertiary amines and in which the nitrogen atoms have two or more fused aromatic rings bonded thereto as substituents, the aromatic amine compounds being represented by 4,4'-bis[N-(1-naphthyl)-N-phenylamino]biphenyl (JP-A-5-234681), aromatic amine compounds having a starburst structure, such as 4,4',4"-tris(1-naphthylphenylamino)triphenylamine (Journal of Luminescence, Vol.72-74, p.985, 1997), the aromatic amine compound constituted of the tetramer of triphenylamine (*Chemical Communications,* p.2175, 1996), fluorene compounds such as 2,2',7,7'-tetrakis(diphenylamino)-9,9'-spirobifluorene (Synthetic Metals, Vol.91, p.209,1997), 2,5-bis(1-naphthyl)-1,3,4-oxadiazole (BND), 2,5-bis[6'-(2',2''-bipyridyl)]-1,1-dimethyl-3,4-diphenylsilole (PyPySPyPy), bathophenanthroline (BPhen), 2,9-dimethyl-4,7-diphenyl-1,10-phenanthroline (BCP; bathocuproine), 2-(4-biphenylyl)-5-(p-tert-butylphenyl)-1,3,4-oxadiazole (tBu-PBD), and 4,4'-bis(9-carbazole)biphenyl (CBP).

The charge transport material in the invention has any desired molecular weight unless the effects of the invention are considerably lessened thereby. However, the molecular weight thereof is usually preferably 10,000 or less, more preferably 5,000 or less, even more preferably 4,000 or less, especially preferably 3,000 or less. Meanwhile, the molecular weight thereof is usually preferably 100 or higher, more preferably 200 or higher, even more preferably 300 or higher, especially preferably 400 or higher.

When the molecular weight of the charge transport material is not lower than the lower limit, this charge transport

material is low in glass transition temperature, melting point, decomposition temperature, etc. as in the case of the luminescent material. Consequently, the luminescent layer obtained using the luminescent layer material and this charge transport material has high heat resistance and is less susceptible to a decrease in luminescent-layer quality due to recrystallization, migration of molecules, etc. or to an increase in impurity concentration, a decrease in element performance, or the like which each accompany thermal decomposition of the material. Such a molecular weight hence is preferred.

On the other hand, when the molecular weight of the charge transport material is not higher than the upper limit, this charge transport material has high solubility irrespective of the kinds of the other starting materials for luminescent-layer formation and of the organic solvent, etc., and is easy to purify to attain a reduction in impurity concentration. Consequently, the organic electroluminescent element is less susceptible to a decrease in luminescent efficiency or durability. Such a molecular weight hence is preferred. Furthermore, such a molecular weight is preferred also because use of this charge transport material facilitates even application and film formation and the element produced using this luminescent layer is less apt to have black spots or short circuits.

[Methods for Film Formation]

Methods for forming the luminescent layer according to the invention are not particularly limited unless the effects of the invention are lessened. For forming the luminescent layer according to the invention, either a wet film formation method or a vacuum deposition method may be used. In the case where the luminescent layer according to the invention is to be formed by a wet film formation method, examples of the methods include a method in which a solution prepared by dissolving the luminescent material and the charge transport material in an organic solvent is applied and then dried to thereby form a film.

As the organic solvent for film formation, any desired solvent can be used so long as the luminescent layer can be formed therewith. Suitable examples of the organic solvent for luminescent-layer formation and application methods are the same as the organic solvents and application methods described above in (Formation of Hole Transport Layer by Wet Film Formation Method) under the section [Methods for Film Formation].

The content of the organic solvent in the composition for luminescent-layer formation is not limited unless the effects of the invention are considerably lessened. However, the content thereof is usually preferably 0.01% by weight or higher, and is usually preferably 70% by weight or less. In the case where two or more organic solvents are used in combination as the organic solvent for luminescent-layer formation, it is preferred that the total amount of these organic solvents should be regulated so as to satisfy that range.

(Other Ingredients)

The luminescent layer according to the invention may contain only one luminescent material and only one charge transport material, or may contain two or more luminescent materials in any desired combination and proportion and two or more charge transport materials in any desired combination and proportion. Furthermore, the luminescent layer in the invention may contain ingredients other than the luminescent material and charge transport material unless the excellent effects of the invention are considerably lessened.

The total concentration of the solid matter including the luminescent material and the charge transport material in the composition for luminescent-layer formation is usually preferably 0.01 % by weight or higher, and is usually preferably 70% by weight or less. When the total concentration thereof is not higher than the upper limit, unevenness in film thickness is less apt to arise. When the total concentration thereof is not less than the lower limit, film defects are less apt to result.

Also in the case where the luminescent layer is to be formed by a vacuum deposition method, the layer can be produced in the same manner as described above in (Formation of Hole Transport Layer by Vacuum Deposition Method) under the section [Methods for Film Formation].

The thickness of the luminescent layer is not limited unless the effects of the invention are considerably lessened. Larger luminescent-layer thicknesses are preferred from the standpoint of avoiding film defects, and the thickness thereof is usually preferably 3 nm or more, more preferably 5 nm or more. Meanwhile, smaller luminescent-layer thicknesses are preferred from the standpoint of facilitating a reduction in operating voltage, and the thickness thereof is usually preferably 200 nm or less, more preferably 100 run or less.

[With respect to Expression (1) to Expression (4)]

The organic electroluminescent element of the invention satisfies the following expressions (1) to (4).

$$EA_{HTL} < EA_{Dopant} \leq EA_{Host} \quad (1)$$

$$0 \leq (EA_{Host} - EA_{Dopant}) \leq 0.7 \text{ eV} \quad (2)$$

$$IP_{Dopant} < IP_{HTL} \leq IP_{Host} \quad (3)$$

$$0 \leq (IP_{Host} - IP_{Dopant}) \leq 0.7 \text{ eV} \quad (4)$$

(In the expressions, $EA_{HTL}$ represents the electron affinity (eV) of the hole-transporting compound having a partial structure shown by formula (5),
$EA_{Dopant}$ represents the electron affinity (eV) of the luminescent material,
$EA_{Host}$ represents the electron affinity (eV) of the charge transport material,
$IP_{HTL}$ represents the ionization potential (eV) of the hole-transporting compound having a partial structure shown by formula (5),
$IP_{Dopant}$ represents the ionization potential (eV) of the luminescent material, and
$IP_{Host}$ represents the ionization potential (eV) of the charge transport material.)

When the organic electroluminescent element of the invention satisfies expression (1), not only electrons are less apt to be injected from the charge transport material into the hole-transporting compound because of the barrier present at the interface between the charge transport material and the hole-transporting compound, but also electrons are less apt to move from the charge transport material to the luminescent material because the electron affinity of the luminescent material is lower than the electron affinity of the charge transport material. It is hence expected that the electrons which have been injected into the luminescent layer are less apt to move via the luminescent material to the hole-transporting compound contained in the hole transport layer. Namely, the hole transport layer (hole-transporting compound) is less apt to be reduced and deteriorated by electrons. It is therefore preferred that expression (1) should be satisfied.

There are no particular limitations on the difference between $EA_{HTL}$ and $EA_{Dopant}$ in expression (1), so long as the difference is not nil.

It is preferred that $(EA_{Dopant}-EA_{HTL})$ should be larger from the standpoints that electrons are less apt to move from the luminescent material to the hole-transporting compound contained in the hole transport layer, that electrons are apt to accumulate in the luminescent layer, that the hole-transporting compound contained in the hole transport layer is less apt to be reduced and deteriorated by electrons, and that the element is apt to have a prolonged working life.

Consequently, $(EA_{Dopant}-EA_{HTL})$ specifically is preferably 0.05 eV or more, more preferably 0.09 eV or more. Meanwhile, smaller values of $(EA_{Dopant}-EA_{HTL})$ are preferred from the standpoint that $IP_{Dopant}<IP_{HTL}$ is apt to result. Consequently, $(EA_{Dopant}-EA_{HTL})$ specifically is preferably 0.7 eV or less, more preferably 0.6 eV or less, especially preferably 0.5 eV or less.

When the organic electroluminescent element of the invention satisfies expression (2), it is expected that the electrons present in the charge transport material contained in the luminescent layer are less apt to move to the luminescent material. Namely, the luminescent material is less apt to be reduced and deteriorated by electrons. It is therefore preferred that expression (2) should be satisfied.

With respect to the relationship between $EA_{Host}$ and $EA_{Dopant}$ in expression (2), $EA_{Host}$ is equal to or larger than $EA_{Dopant}$. Furthermore, it is preferred that $(EA_{Host}-EA_{Dopant})$ in expression (2) should be larger from the standpoint that electrons are less apt to move from the charge transport material to the luminescent material.

In this connection, when electrons are less apt to move to the luminescent material, electrons are less apt to accumulate in the luminescent material. As a result, the luminescent material is less apt to be reduced and deteriorated by electrons, and this is apt to result in a prolongation of element working life. Consequently, $(EA_{Host}-EA_{Dopant})$ specifically is 0 eV or more, preferably 0.1 eV or more, more preferably 0.15 eV or more.

Meanwhile, however, smaller values of $(EA_{Host}-EA_{Dopant})$ are preferred from the standpoints that a small value of $(IP_{Host}-IP_{Dopant})$ results, that the luminescent material is less susceptible to oxidative deterioration due to hole accumulation, and that the element is apt to have a prolonged working life. Consequently, $(EA_{Host}-EA_{Dopant})$ specifically is 0.7 eV or less, preferably 0.5 eV or less, more preferably 0.3 eV or less.

When the organic electroluminescent element of the invention satisfies expression (3), it is expected that the holes which have been injected into the hole-transporting compound contained in the hole transport layer are apt to move to the charge transport material without via the luminescent material. Namely, holes are less apt to accumulate

in the luminescent material, the element is apt to have an increased luminescent efficiency, and the luminescent material is less susceptible to oxidative deterioration. It is therefore preferred that expression (3) should be satisfied.

There are no particular limitations on the difference between $IP_{Dopant}$ and $IP_{HTL}$ in expression (3), so long as the difference is not nil. With respect to the relationship between $IP_{HTL}$ and $IP_{Host}$, $IP_{HTL}$ is equal to $IP_{Host}$, or $IP_{Host}$ is larger than $IP_{HTL}$.

When the ionization potentials have the relationship represented by expression (3), holes are apt to move from the hole-transporting compound contained in the hole transport layer to the charge transport material without via the luminescent material. As a result, the luminescent material is less susceptible to oxidative deterioration and this is apt to result in a prolongation of element working like. Furthermore, holes are less apt to accumulate in the hole-transporting compound contained in the hole transport layer, and this is apt to result in an increase in the luminescent efficiency of the element.

It is preferred that ($IP_{HTL}$-$IP_{Dopant}$) should be larger. Consequently, ($IP_{HTL}$-$IP_{Dopant}$) specifically is preferably 0.01 eV or more, more preferably 0.02 eV or more. Meanwhile, however, ($IP_{HTL}$-$IP_{Dopant}$) is preferably 0.7 eV or less, more preferably 0.6 eV or less, even more preferably 0.5 eV or less.

When expression (4) is satisfied, the holes which have been transferred from the charge transport material to the luminescent material are less apt to accumulate in the luminescent material. Namely, the luminescent material can be prevented from being oxidized and decomposed by holes and being thereby deteriorated, and the probability of recombination within the luminescent layer becomes higher. It is hence preferred that expression (4) should be satisfied.

When the organic electroluminescent element of the invention satisfies expression (4), it is expected that the holes which have been injected into the hole-transporting compound contained in the hole transport layer are less apt to move to the luminescent material. Namely, holes are less apt to accumulate in the luminescent material, and the luminescent material is less susceptible to oxidative deterioration. It is therefore preferred that expression (4) should be satisfied,

With respect to the relationship between $IP_{Host}$ and $IP_{Dopant}$ in expression (4), $IP_{Host}$ is equal to or larger than $IP_{Dopant}$. Furthermore, it is preferred that ($IP_{Host}$-$IP_{Dopant}$) in expression (4) should be smaller, from the standpoint of facilitating the movement of holes from the charge transport material to the luminescent material within the luminescent layer.

When holes are thus apt to move from the hole-transporting compound contained in the hole transport layer to the charge transport material without via the luminescent material, the luminescent material is less susceptible to oxidative deterioration and this is apt to result in a prolongation of element working life. In addition, holes are less apt to accumulate in the hole-transporting compound contained in the hole transport layer, and this is apt to result in an increase in the luminescent efficiency of the element. Consequently, ($IP_{Host}$-$IP_{Dopant}$) specifically is 0.7 eV or less, preferably 0.6 eV or less, more preferably 0.5 eV or less.

Meanwhile, however, larger values of ($IP_{Host}$-$IP_{Dopant}$) are preferred from the standpoint that a larger value of ($EA_{Host}$-$EA_{Dopant}$) is apt to result. Specifically, ($IP_{Host}$-IPDopant) is 0 eV or more, preferably 0.1 eV or more, more preferably 0.2 eV or more.

(Electron Affinity and Ionization Potential of Hole-transporting Compound contained in Hole Transport Layer)

The electron affinity ($EA_{HTL}$) of the hole-transporting compound which has a partial structure shown by formula (5) given above and which is contained in the hole transport layer according to the invention is determined by the determination method which will be described later under the section [Method for Determining Electron Affinity (EA)].

It is preferred that the electron affinity ($EA_{HTL}$) should be higher from the standpoint that the hole-transporting compound which has a partial structure shown by formula (5) and which is contained in the hole transport layer has a larger value of ionization potential ($IP_{HTL}$) and that holes are apt to move from the hole-transporting compound contained in the hole transport layer to the luminescent layer. Meanwhile, smaller values of the electron affinity ($EA_{HTL}$) are preferred from the standpoint of facilitating the relationship represented by expression (1).

Consequently, the electron affinity ($EA_{HTL}$) of the hole-transporting compound is usually preferably 2.0 eV or higher, more preferably 2,2 eV or higher, even more preferably 2.3 eV or higher. Meanwhile, the electron affinity ($EA_{HTL}$) is usually preferably 3.0 eV or less, more preferably 2.9 eV or less, even more preferably 2.8 eV or less.

In the case where a plurality of hole-transporting compounds having a partial structure shown by formula (5) are contained in the hole transport layer, it is preferred that the lowest of the values of electron affinity ($EA_{HTL}$) should satisfy expressions (1) and (2).

The ionization potential ($IP_{HTL}$) of the hole-transporting compound which has a partial structure shown by formula (5) given above and which is contained in the hole transport layer according to the invention is determined by the determination method which will be described later under the section [Method for Determining Ionization Potential (IP)].

It is preferred that the ionization potential ($IP_{HTL}$) should be higher from the standpoint that holes are apt to move from the hole-transporting compound contained in the hole transport layer to the luminescent layer. Meanwhile,

smaller values of the ionization potential ($IP_{HTL}$) are preferred from the standpoint of ease of selection of a luminescent material which satisfies expression (4).

Consequently, the ionization potential ($IP_{HTL}$) is usually preferably 4.8 eV or higher, more preferably 5.0 eV or higher, even more preferably 5.2 eV or higher. Meanwhile, the ionization potential ($IP_{HTL}$) is usually preferably 6.4 eV or less, more preferably 6.0 eV or less, even more preferably 5.8 eV or less.

In the case where a plurality of hole-transporting compounds having a partial structure shown by formula (5) are contained in the hole transport layer, it is preferred that the highest of the values of ionization potential ($IP_{HTL}$) should satisfy expressions (3) and (4).

(Electron Affinity and Ionization Potential of Luminescent Material)

The electron affinity ($EA_{Dopant}$) of the luminescent material according to the invention is determined by the determination method which will be described later under the section [Method for Determining Electron Affinity (EA)].

It is preferred that the electron affinity ($EA_{Dopant}$) of the luminescent material should be higher from the standpoints that electrons are less apt to move from the luminescent material to the hole-transporting compound contained in the hole transport layer, that electrons are apt to accumulate in the luminescent layer, and that the hole-transporting compound contained in the hole transport layer is less apt to be reduced and deteriorated by electrons and this is apt to result in a prolongation of element working life. Consequently, the electron affinity ($EA_{Dopant}$) of the luminescent material specifically is preferably 2.0 eV or higher, more preferably 2.2 eV or higher, especially preferably 2.3 eV or higher.

Meanwhile, however, smaller values of the electron affinity ($EA_{Dopant}$) of the luminescent material are preferred from the standpoints that the relationship with the charge transport material satisfies expression (1), that electrons are less apt to move from the charge transport material to the luminescent material, and that the luminescent material is less susceptible to reductional deterioration. Consequently, the electron affinity ($EA_{Dopant}$) of the luminescent material specifically is preferably 3.1 eV or less, more preferably 3.0 eV or less, especially preferably 2.9 eV or less.

In the case where a plurality of luminescent materials are contained in the luminescent layer, it is preferred that the lowest of the values of the electron affinity ($EA_{HTL}$) should satisfy expressions (1) and (2).

The ionization potential ($IP_{Dopant}$) of the luminescent material according to the invention is determined by the determination method which will be described later under the section [Method for Determining Ionization Potential (IP)].

It is preferred that the ionization potential ($IP_{Dopant}$) of the luminescent material should be lower from the standpoint of ease of satisfying the relationship represented by expression (3). Consequently, the ionization potential ($IP_{Dopant}$) of the luminescent material specifically is preferably 6.0 eV or less, more preferably 5.9 eV or less, especially preferably 5.8 eV or less.

Meanwhile, however, larger values of the ionization potential ($IP_{Dopant}$) of the luminescent material are preferred from the standpoints that the electron affinity of the hole-transporting compound contained in the hole transport layer and the electron affinity of the luminescent material are apt to satisfy the relationship represented by expression (1) and that a charge transport material which satisfies the relationship represented by expression (4) is easy to select. Consequently, the ionization potential ($IP_{Dopant}$) of the luminescent material specifically is preferably 5.0 eV or higher, more preferably 5.1 eV or higher, especially preferably 5.2 eV or higher.

In the case where a plurality of luminescent materials are contained in the luminescent layer, it is preferred that the highest of the values of the ionization potential ($IP_{HTL}$) should satisfy expressions (3) and (4).

(Electron Affinity and Ionization Potential of Charge Transport Material)

The electron affinity ($EA_{Host}$) of the charge transport material according to the invention is determined by the determination method which will be described later under the section [Method for Determining Electron Affinity (EA)].

It is preferred that the electron affinity ($EA_{Host}$) of the charge transport material should be higher from the standpoint of ease of satisfying the relationship represented by expression (1). Consequently, the electron affinity ($E_{AHost}$) of the charge transport material specifically is preferably 2.3 eV or higher, more preferably 2.4 eV or higher, especially preferably 2.5 eV or higher.

Meanwhile, however, smaller values of the electron affinity ($EA_{Host}$) of the charge transport material are preferred from the standpoint of ease of selecting a luminescent material which satisfies the relationship represented by expression (2). Consequently, the electron affinity ($EA_{Host}$) of the charge transport material specifically is preferably 3.1 eV or less, more preferably 3.0 eV or less, especially preferably 2.9 eV or less.

In the case where a plurality of charge transport materials are contained in the luminescent layer, it is preferred that the highest of the values of electron affinity ($EA_{HTL}$) of the charge transport materials each contained in the luminescent layer in an amount of 5% by weight or more should satisfy expressions (1) and (2).

The ionization potential ($IP_{Host}$) of the charge transport material according to the invention is determined by the determination method which will be described later under the section [Method for Determining Ionization Potential (IP)].

It is preferred that the ionization potential ($IP_{Host}$) of the charge transport material should be higher from the standpoint of ease of satisfying the relationship represented by expression (3). Consequently, the ionization potential ($IP_{Host}$) of the charge transport material specifically is preferably 5.0 eV or higher, more preferably 5.2 eV or higher, especially preferably 5.4 eV or higher.

Meanwhile, however, smaller values of the ionization potential ($IP_{Host}$) of the charge transport material are preferred from the standpoint of ease of selecting a luminescent material which satisfies the relationship represented by expression (4). Consequently, the ionization potential ($IP_{Host}$) of the charge transport material specifically is preferably 6.5 eV or less, more preferably 6.3 eV or less, especially preferably 6.1 eV or less.

In the case where a plurality of charge transport materials are contained in the luminescent layer, it is preferred that the lowest of the values of ionization potential ($IP_{HTL}$) of the charge transport materials each contained in the luminescent layer in an amount of 5% by weight or more should satisfy expressions (3) and (4).

The preferred hole-transporting compounds, luminescent materials, and charge transport materials shown above are apt to satisfy those preferred ranges of electron affinity and ionization potential. Consequently, by determining beforehand the electron affinity and ionization potential of each of these preferred materials by the following methods, materials which satisfy the relationships represented by expressions (1) to (4) according to the invention can be selected. It is preferred that this material selection should be conducted in such a manner that a luminescent material is selected first and a charge transport material and a hole-transporting compound are subsequently selected in this order.

[Method for Determining Ionization Potential (IP)]

When the object to be measured is a substance which is not a transition metal complex, the ionization potential thereof can be determined with a commercial ionization potential measuring apparatus. When the object to be measured is a transition metal complex, the ionization potential thereof can be determined through an electrochemical measurement. Examples of the commercial ionization potential measuring apparatus include AC-1, AC-2, and AC-3 (manufactured by Riken Keiki Co., Ltd.) and PCR-101 and PCR-201 (manufactured by Optel Ltd.). Measuring apparatuses other than those apparatuses may be used so long as an ionization potential measurement is possible therewith. In the Examples which will be given later, measurements were made with PCR-101 among those apparatuses.

Ionization potential usually is determined by forming a film of the substance to be measured, by a wet film formation method, vacuum deposition method, or the like, and measuring the ionization potential of the film. In the case where an ionization potential measurement is to be made using a wet film formation method, the specific procedure is, for example, as follows. The material to be measured is dissolved in an organic solvent, and the solution is applied on a substrate by, for example, spin coating. The ionization potential of the resultant film is measured.

As the organic solvent, any organic solvent may be used so long as the material to be measured can be evenly dissolved therein and the solvent is a transparent organic solvent. Examples of the organic solvent include xylene and toluene.

As the substrate, use is made, for example, of a glass, ITO substrate, metal plate, silicon substrate, or the like.

[Method for Determining Electron Affinity (EA)]

When the object to be measured is a substance which is not a transition metal complex, the electron affinity thereof can be determined by examining an absorption spectrum of a single-layer film of the material to be measured, the spectrum being obtained with a commercial apparatus capable of absorption spectrophotometry. When the object to be measured is a transition metal complex, the electron affinity thereof can be determined through an electrochemical measurement. Examples of the commercial apparatus for ionization potential measurement include F4500 (manufactured by Hitachi, Ltd.). Measuring apparatuses other than that apparatus may be used so long as absorption spectrophotometry is possible therewith. In the Examples which will be given later, measurements were made with F4500 among those apparatuses.

Specifically, a film of the material to be measured is formed on a transparent substrate in the same manner as in the method for determining ionization potential described above and this film can be used to obtain an absorption spectrum thereof. A band gap is calculated from the absorption spectrum, and an electron affinity can be calculated from the band gap and from the value of ionization potential.

In the case where ionization potential or electron affinity is determined through an electrochemical measurement, the measurement is usually made in the following manner. The material to be measured is dissolved, in a concentration of 0.1-2 mM, in an organic solvent which contains tetrabutylammonium perchlorate, tetrabutylammonium hexafluorophosphate, or the like as a supporting electrolyte in an amount of 0.1 mol/L. A glassy-carbon electrode is used as a working electrode, and a platinum electrode is used as a counter electrode. Furthermore, a silver wire is used as a reference electrode. Electrolytic oxidation (or reduction) of the material to be measured is conducted using these electrodes, and the potentials thereof are compared with the oxidation/reduction potential of a reference substance such as

ferrocene to thereby calculate the oxidation (reduction) potential of the material.

As the organic solvent, use is made of an organic solvent in which the material to be measured is soluble and which itself is less susceptible to electrolytic oxidation (reduction) and enables a wide potential window, such as acetonitrile, methylene chloride, tetrahydrofuran, etc.

The oxidation potential and reduction potential calculated by the procedure described above respectively correspond to the ionization potential and electron affinity of the material. Incidentally, the supporting electrolyte, solvent, and electrodes are not limited to the examples used above, and other electrolytes, solvents, and electrodes may be used so long as the same measurement is possible therewith.

<Configuration of the Organic Electroluminescent Element>

An example of the layer configuration of the organic electroluminescent element of the invention is explained below by reference to Fig. 1. The layer configuration of the organic electroluminescent element of the invention, processes for producing the configuration, etc. should not be construed as being limited to the following.

Fig. 1 is a diagrammatic view illustrating an example of the cross-sectional structure of an organic electroluminescent element according to the invention. In Fig. 1, numeral 1 denotes a substrate, 2 an anode, 3 a hole injection layer, 4 a hole transport layer, 5 a luminescent layer, 6 a hole blocking layer, 7 an electron transport layer, 8 an electron injection layer, and 9 a cathode.

The hole transport layer and the luminescent material and charge transport material which are contained in the luminescent layer in Fig. 1 satisfy expressions (1) to (4).

(Substrate)

The substrate serves as the base of the organic electroluminescent element. Examples of the material of the substrate include quartz and glass plates, metal sheets, metal foils, and plastic films and sheets. The substrate preferably is a glass plate or a transport plate of, for example, a synthetic resin such as a polyester, polymethacrylate, polycarbonate, polysulfone, etc.

In the case where a synthetic-resin substrate is used, it is preferred to take account of the gas barrier properties of the substrate. Namely, when a resin having low gas barrier properties is used, it is preferred that a dense silicon oxide film or the like should be disposed on at least one surface of the substrate in order to inhibit element deterioration due to the surrounding atmosphere.

(Anode)

The anode is an electrode which serves to inject holes into a layer located on the luminescent-layer side. This anode usually is constituted of a metal, e.g., aluminum, gold, silver, nickel, palladium, or platinum, a metal oxide, e.g., an indium and/or tin oxide, a metal halide, e.g., copper iodide, carbon black, a conductive polymer, e.g., poly(3-methylthiophene), polypyrrole, or polyaniline, or the like.

Usually, an anode is frequently formed by sputtering, vacuum deposition, or the like. In the case where an anode is to be formed using fine particles of a metal, e.g., silver, fine particles of copper iodide or the like, carbon black, fine particles of a conductive metal oxide, fine particles of a conductive polymer, or the like, use may be made of a method in which such a material is dispersed in an appropriate binder resin solution and the dispersion is applied to a substrate to thereby form an anode.

Furthermore, in the case of an anode constituted of a conductive polymer, this electrode can be obtained, for example, by directly forming a thin film on a substrate by electrolytic polymerization or by applying the conductive polymer to a substrate to form an anode (Appl. Phys. Lett., Vol.60, p.2711, 1992).

The anode usually has a single-layer structure. However, the anode can be made to have a multilayer structure composed of a plurality of materials, according to need.

The thickness of the anode may be regulated to any desired value according to the transparency required, etc. Especially when transparency is required, the visible-light transmittance of the anode is usually preferably 60% or higher, more preferably 80% or higher.

In this case, the thickness of the anode is usually preferably 1,000 nm or less, more preferably 500 nm or less. Meanwhile, the thickness of the anode is usually preferably 5 nm or more, more preferably 10 nm or more.

In the case where the anode may be opaque, this anode can have any desired thickness. For example, the anode may have the same thickness as the substrate. Furthermore, a different conductive material may have been superposed on the anode.

It is preferred that the anode should be subjected to a surface treatment before use to thereby remove impurities and the like adherent to the surface and to simultaneously regulate the ionization potential of the anode and improve

hole injection properties beforehand. Examples of the anode surface treatment include: ultraviolet irradiation + ozone treatment; oxygen plasma treatment; and argon plasma treatment.

(Hole Injection Layer)

The hole injection layer is a layer which transports holes from the anode to the luminescent layer. In the invention, the hole injection layer is not an essential layer, In the case where a hole injection layer is to be disposed, the hole injection layer is formed usually between the anode and the hole transport layer.

Methods for forming the hole injection layer according to the invention are not particularly limited, and either a vacuum deposition method or a wet film formation method may be used. However, a wet film formation method is preferred from the standpoint of diminishing dark spots.

The thickness of the hole injection layer is usually preferably 5 nm or more, more preferably 10 nm or more. Meanwhile, the thickness of the hole injection layer is usually preferably 1,000 nm or less, more preferably 500 nm or less.

Formation of the hole injection layer by a wet process can be conducted in the same manner as in the wet-process formation of the hole transport layer. Namely, raw materials for the hole injection layer are dissolved in an organic solvent (organic solvent for hole injection layer formation) to thereby prepare a composition for film formation (composition for hole injection layer formation). This composition for hole injection layer formation is applied to the layer (usually, the anode) which is to underlie the hole injection layer, and the resultant film is dried to thereby form a hole injection layer.

(Hole-transporting Compound)

The composition for hole injection layer formation usually includes a hole-transporting compound, as a material for constituting a hole injection layer, and an organic solvent.

The hole-transporting compound may usually be a compound which has hole-transporting properties and is for use in the hole injection layers of organic electroluminescent elements. Although the hole-transporting compound may be a high-molecular compound such as a polymer or a low-molecular compound such as a monomer, it is preferred that the hole-transporting compound should be a high-molecular compound.

From the standpoint of a barrier to charge injection from the anode to the hole injection layer, it is preferred that the hole-transporting compound should have an ionization potential of 4,5-6,0 eV.

Examples of the hole-transporting compound include aromatic amine derivatives, phthalocyanine derivatives, porphyrin derivatives, oligothiophene derivatives, polythiophene derivatives, benzylphenyl derivatives, a compound including tertiary amines linked with a fluorene group, hydrazone derivatives, silazane derivatives, silanamine derivatives, phosphamine derivatives, quinacridone derivatives, polyaniline derivatives, polypyrrole derivatives, polyphenylenevinylene derivatives, polythienylenevinylene derivatives, polyquinoline derivatives, polyquinoxaline derivatives, and carbon.

Incidentally, the term "derivative" in the invention has the following meaning. In the case of aromatic amine derivatives, for example, the term "aromatic amine derivatives" includes the aromatic amine itself and compounds having the aromatic amine as the main framework. The aromatic amine derivatives may be polymers or monomers.

Any one of such hole-transporting compounds may be contained alone as a material for the hole Injection layer, or two or more thereof may be contained as the material. In the case where two or more hole-transporting compounds are contained, such compounds may be used in any desired combination and proportion. However, it is preferred to use one or more aromatic tertiary amine high-molecular compounds in combination with one or more other hole-transporting compounds.

Of the compounds shown above as examples, aromatic amine compounds are preferred from the standpoints of noncrystallinity and visible-light transmittance.
In particular, aromatic tertiary amine compounds are preferred, The term "aromatic tertiary amine compound" herein means a compound having an aromatic tertiary amine structure, and includes a compound having a group derived from an aromatic tertiary amine.

The kind of aromatic tertiary amine compound is not particularly limited. The aromatic tertiary amine compound preferably is a compound which is apt to cause even luminescence based on the effect of surface smoothing. From this standpoint, it is preferred that the aromatic tertiary amine compound should be a high-molecular compound (polymeric compound made up of consecutive repeating units) having a weight-average molecular weight of 1,000-1,000,000.

Preferred examples of the aromatic tertiary amine high-molecular compound include high-molecular compounds having repeating units represented by the following formula (I) and the following formulae.

[Chem. 34]

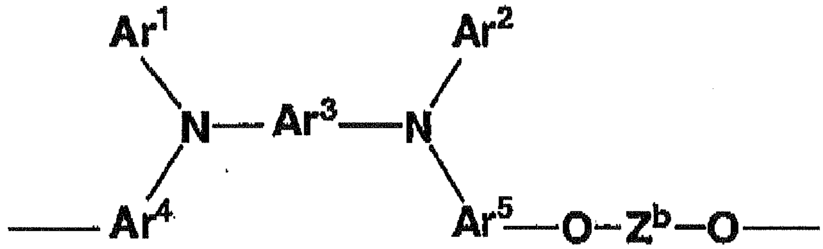

(I)

[In formula (I), $Ar^1$ and $Ar^2$ each independently represent an aromatic hydrocarbon ring group which may have a substituent or an aromatic heterocyclic group which may have a substituent. $Ar^3$ to $Ar^5$ each independently represent an aromatic hydrocarbon ring group which may have a substituent or an aromatic heterocyclic group which may have a substituent. $Z^b$ represents a linking group selected from the following linking groups. Of $Ar^1$ to $Ar^5$, two groups bonded to the same nitrogen atom may be bonded to each other to form a ring.]

[Chem. 35]

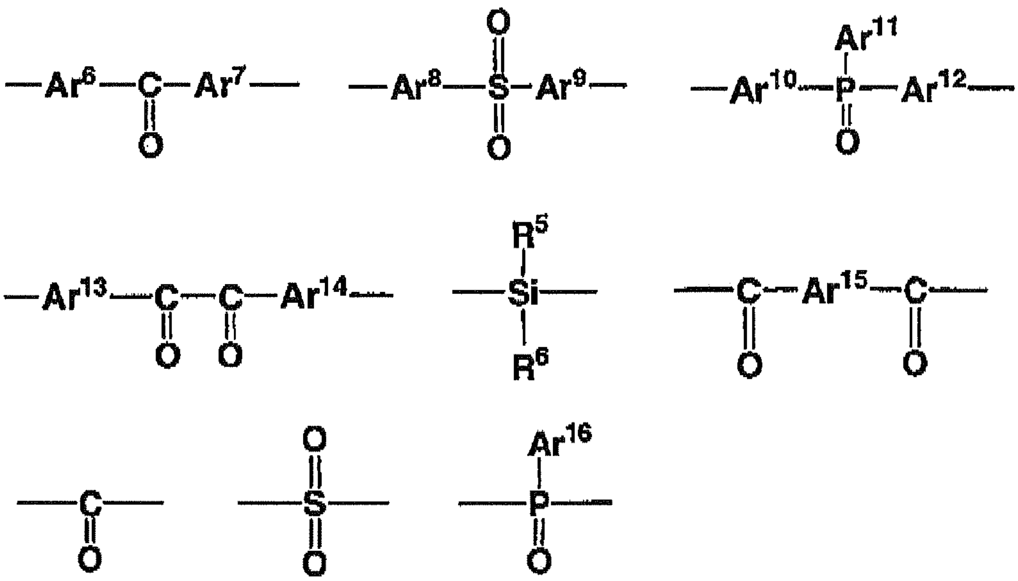

(In the formulae, $Ar^6$ to $Ar^{16}$ each independently represent an aromatic hydrocarbon ring group which may have a substituent or an aromatic heterocyclic group which may have a substituent. $R^5$ and $R^6$ each independently represent a hydrogen atom or any desired substituent.)

The aromatic hydrocarbon ring groups and aromatic heterocyclic groups represented by $Ar^1$ to $Ar^{16}$ preferably are groups derived from a benzene ring, naphthalene ring, phenanthrene ring, thiophene ring, and pyridine ring, from the standpoints of the solubility, heat resistance, and hole injection/transport properties of the high-molecular compound. More preferred are groups derived from a benzene ring and a naphthalene ring.

The aromatic hydrocarbon ring groups and aromatic heterocyclic groups represented by $Ar^1$ to $Ar^{16}$ may have further substituents. The molecular weights of the substituents are usually preferably 400 or less, more preferably 250 or less. Preferred examples of the substituents are alkyl groups, alkenyl groups, alkoxy groups, aromatic hydrocarbon ring groups, aromatic heterocyclic groups, and the like.

In the case where $R^1$ and $R^2$ are any desired substituents, examples of the substituents include alkyl groups, alkenyl groups, alkoxy groups, silyl group, siloxy group, aromatic hydrocarbon ring groups, and aromatic heterocyclic groups.

Specific examples of the aromatic tertiary amine high-molecular compounds having a repeating unit represented by formula (I) include the compounds described in International Publication No. 2005/089024.

Also preferred as a hole-transporting compound is a conductive polymer (PEDOT/PSS) obtained by polymerizing 3,4-ethylenedioxythiophene in high-molecular poly(styrenesulfonic acid), the conductive polymer being a derivative of polythiophene. This polymer which has been modified by capping the ends thereof with a methacrylate or the like is also suitable.

The hole-transporting compound may be a compound which contains any of the crosslinkable groups described above under the section [Hole Transport Layer]. In this case, a film can be formed in the same manner as described above under the section [Hole Transport Layer].

Incidentally, the hole injection layer may contain any of the electron-accepting compounds mentioned above. In the case where an electron-accepting compound is used, examples thereof include the electron-accepting compounds shown above under the section [Hole Transport Layer.

The concentration of the hole-transporting compound in the composition for hole injection layer formation is not limited unless the effects of the invention are considerably lessened. It is preferred that the concentration of the hole-transporting compound in the composition for hole injection layer formation should be higher from the standpoint of forming a hole injection layer which has few defects.

Specifically, the concentration thereof is usually preferably 0.01% by weight or higher, more preferably 0.1% by weight or higher, even more preferably 0.5% by weight or higher. Meanwhile, from the standpoint of forming a hole injection layer which has little unevenness in film thickness, it is preferred that the concentration of the hole-transporting compound in the composition for hole injection layer formation should be lower. Specifically, the concentration thereof is usually preferably 70% by weight or less, more preferably 60% by weight or less, even more preferably 50% by weight or less.

(Hole Transport Layer)

The hole transport layer according to the invention is as explained above under the section [Hole Transport Layer].

(Luminescent Layer)

The luminescent layer according to the invention is as explained above under the section [Hole Transport Layer].

(Hole Blocking Layer)

A hole blocking layer may be disposed in the organic electroluminescent element of the invention. Usually, a hole blocking layer is disposed between the luminescent layer and the cathode. In the case where the electron transport layer and electron injection layer which will be described later are disposed in the organic electroluminescent element of the invention, a hole blocking layer usually is disposed between the luminescent layer and either the electron transport layer or the electron injection layer.

The hole blocking layer not only serves to prevent the holes which have moved from the anode from reaching the cathode but also serves to efficiently transport, toward the luminescent layer, the electrons which have been injected from the cathode.

Examples of the properties which are required of the material constituting the hole blocking layer include high electron mobility, low hole mobility, a large energy gap (difference between HOMO and LUMO), and a high excited triplet level (T1). The following materials are preferred for the hole blocking layer because the following materials are apt to satisfy such properties. However, the hole blocking material according to the invention should not be construed as being limited to the following materials.

Namely, examples of materials for the hole blocking layer include mixed-ligand complexes such as bis(2-methyl-8-quinolinolato)(phenolato)aluminum and bis(2-methyl-8-quinolinolato)(triphenylsinolato)aluminum, metal complexes such as dinuclear metal complexes, e.g., bis(2-methyl-8-quinolato)aluminum-$\mu$-oxo-bis(2-methyl-8-quinolilato)aluminum, styryl compounds such as distyrylbiphenyl derivatives (JP-A-11-242996), triazole derivatives such as 3-(4-biphenylyl)-4-phenyl-5-(4-tert-butylphenyl)-1,2,4-triazole (JP-A-7-41759), and phenanthroline derivatives (JP-A-10-79297). Furthermore, the compound which has at least one pyridine ring substituted in the 2-, 4-, and 6-positions and which is described in International Publication No. 2005-022962 also is a preferred material for the hole blocking layer.

One material only may be used for constituting the hole blocking layer, or two or more materials may be used for constituting the layer in any desired combination and proportion.

Methods for forming the hole blocking layer are not limited. The hole blocking layer can be formed by a method such as a wet film formation method or a vapor deposition method.

The thickness of the hole blocking layer is not particularly limited unless the effects of the invention are considerably lessened. The thickness of the hole blocking layer is usually preferably 0.3 nm or more, more preferably 0.5 nm or more. Meanwhile, the thickness thereof is usually preferably 100 nm or less, more preferably 50 nm or less.

(Electron Transport Layer)

An electron transport layer may be disposed in the organic electroluminescent element of the invention. In the case where an electron transport layer is disposed, the layer usually is disposed between the luminescent layer and the cathode. In the case where the electron injection layer which will be described later is disposed in the organic electroluminescent element of the invention, an electron transport layer usually is disposed between the luminescent layer and the electron injection layer.
The electron transport layer is disposed usually for the purpose of improving the luminescent efficiency of the element. Consequently, the electron transport layer usually is constituted of a compound which is capable of efficiently transporting, toward the luminescent layer, the electrons that have been injected from the cathode, when an electric field is applied to between the anode and the cathode.
As such an electron-transporting compound for constituting the electron transport layer, use is usually made of a compound which attains a high efficiency of electron injection from the cathode side and has high electron mobility and which can efficiently transport injected electrons. Examples of compounds which satisfy such requirements include metal complexes such as aluminum complexes of 8-hydroxyquinoline (JP-A-59-194393), metal complexes of 10-hydroxybenzo[h]quinoline, oxadiazole derivatives, distyrylbiphenyl derivatives, silole derivatives, 3-hdyroxyflavone metal complexes, 5-hydroxyflavone metal complexes, benzoxazole metal complexes, benzothiazole metal complexes, trisbenzimidazolylbenzene (U.S. Patent 5,645,948), quinoxaline compounds (JP-A-6-207169), phenanthroline derivatives (JP-A-5-331459), 2-t-butyl-9,10-N,N'-dicyanoanthraquinonediimine, n-type hydrogenated amorphous silicon carbide, n-type zinc sulfide, and n-type zinc selenide.
One material only may be used for constituting the electron transport layer, or two or more materials may be used for constituting the layer in any desired combination and proportion.
Methods for forming the electron transport layer are not limited. The electron transport layer can be formed by a method such as a wet film formation method or a vapor deposition method.
The thickness of the electron transport layer is not particularly limited unless the effects of the invention are considerably lessened. The thickness of the electron transport layer is usually preferably 1 nm or more, more preferably 5 nm or more. Meanwhile, the thickness thereof is usually preferably 300 nm or less, more preferably 100 nm or less.

(Electron Injection Layer)

An electron injection layer may be disposed in the organic electroluminescent element of the invention. In the case where an electron injection layer is disposed, the electron injection layer usually is disposed between the luminescent layer and the cathode. In the case where the electron transport layer described above is disposed in the organic electroluminescent element of the invention, an electron injection layer usually is disposed between the electron transport layer and the cathode.
The electron injection layer is disposed usually for the purpose of efficiently injecting, toward the luminescent-layer side, the electrons that have been injected from the cathode side. Consequently, it is preferred that the electron injection layer should be a metal which has a low work function. Examples of the electron injection layer include alkali metals such as sodium and cesium and alkaline earth metals such as barium and calcium. In the case where the electron injection layer is any of these metals having a low work function, the thickness thereof is preferably 0.1 nm or more, and is preferably 5 nm or less.
Furthermore, a film obtained by doping an organic electron transport compound represented by a nitrogen-containing heterocyclic compound, e.g., bathophenanthroline, or a metal complex, e.g., an aluminum complex of 8-hydroxyquinoline, with an alkali metal such as sodium, potassium, cesium, lithium, or rubidium (described in JP-A-10-270171, JP-A-2002-100478, JP-A-2002-100482, etc.) is preferred as the electron injection layer because it is easy to impart excellent electron injection/transport properties and excellent film quality to this film.
In this case, the thickness of the electron injection layer is usually preferably 5 nm or more, more preferably 10 nm or more. Meanwhile, the thickness thereof is usually preferably 200 nm or less, more preferably 100 nm or less.
One material only may be used for constituting the electron injection layer, or two or more materials may be used for constituting the layer in any desired combination and proportion.
Methods for forming the electron injection layer are not limited. The electron injection layer can be formed by a method such as a wet film formation method or a vapor deposition method.

(Cathode)

The cathode is an electrode which serves to inject electrons into a layer located on the luminescent-layer side. For constituting the cathode, the same materials as for the anode can be used. It is preferred that the cathode should be a metal which has a low work function, because efficient electron injection into a layer located on the luminescent-layer side is easy with the metal.

Examples of the metal include metals such as tin, magnesium, indium, calcium, aluminum, and silver and alloys of these.

Examples of the alloys include alloys having a low work function, such as magnesium-silver alloys, magnesium-indium alloys, and aluminum-lithium alloys.

One material only may be used for constituting the cathode, or two or more materials may be used for constituting the cathode in any desired combination and proportion.

The cathode can be formed in the same manner as for the anode. The thickness of the cathode usually preferably is the same as the thickness of the anode.

For enhancing the stability of the element, it is preferred that a layer of a metal that has a high work function and is stable to the air should be formed on that surface of the cathode which is on the opposite side from the substrate, thereby protecting the cathode. Examples of the metal to be deposited on the cathode include aluminum, silver, copper, nickel, chromium, gold, and platinum. One of these metals may be used alone, or two or more thereof may be used in any desired combination and proportion.

(Other Layers)

The organic electroluminescent element according to the invention may have an element configuration other than the element configuration described above, unless the other configuration departs from the spirit of the invention. Examples of the other element configuration include: the case where the element has any desired layer(s) other than the layers described above, between the anode and the cathode; the case where there are a plurality of layers which each are any of the layers described above; and the case where any of the layers described above has been omitted.

The organic electroluminescent element according to the invention can be made to have the layer configuration explained above in which the constituent elements excluding the substrate have been superposed in the reverse order. For example, in the case of the layer configuration shown in Fig. 1, the cathode, electron injection layer, electron transport layer, hole blocking layer, luminescent layer, hole transport layer, hole injection layer, and anode may be disposed in this order on the substrate.

It is also possible to constitute an organic electroluminescent element according to the invention by superposing the constituent elements other than the substrate between two substrates, at least one of which is transparent.

Furthermore, an organic electroluminescent element according to the invention can be configured so as to have a structure composed of a stack of stages each composed of constituent elements other than substrates (luminescent units) (i.e., a structure composed of a plurality of stacked luminescent units). In this case, when a carrier generation layer (CGL) made of, for example, vanadium pentoxide ($V_2O_5$) is disposed in place of the interfacial layers located between the stages (i.e., between the luminescent units) (when the anode is ITO and the cathode is aluminum, the interfacial layers are these two layers), then the barrier between the stages is reduced. This configuration is more preferred from the standpoints of luminescent efficiency and operating voltage.

The organic electroluminescent element according to the invention may be configured so as to be a single organic electroluminescent element. Alternatively, a plurality of organic electroluminescent elements which each are the organic electroluminescent element according to the invention may be disposed in an array arrangement.

Moreover, the organic electroluminescent element according to the invention may be made to have a configuration in which anodes and cathodes have been disposed in an X-Y matrix arrangement. Each of the layers described above may contain ingredients other than those explained above as materials for the layer, unless the effects of the invention are considerably lessened thereby.

<Organic EL Display Device>

The organic EL display device of the invention is a display device which employs the organic electroluminescent element of the invention described above. Namely, the organic EL display device of the invention is an organic EL display device which includes the organic electroluminescent element of the invention. The type and structure of the organic EL display device of the invention are not particularly limited. The organic EL display device of the invention can be fabricated using the organic electroluminescent element of the invention according to ordinary methods.

The organic EL display device of the invention can be formed, for example, by the method described in *Yuki* EL Dispurei (Ohmsha, Ltd., published on August 20, 2004, written by TOKITO Shizuo, ADACHI Chihaya, and MURATA Hideyuki).

<Organic EL Illuminator>

The organic EL illuminator of the invention is an illuminator which employs the organic electroluminescent

element of the invention described above. Namely, the organic EL illuminator of the invention is an organic EL illuminator which includes the organic electroluminescent element of the invention. The type and structure of the organic EL illuminator of the invention are not particularly limited. The organic EL illuminator of the invention can be fabricated using the organic electroluminescent element of the invention according to ordinary methods.

## Examples

The invention will be explained below in more detail by reference to Examples, but the invention should not be construed as being limited to the following Examples unless the invention departs from the spirit thereof.

### (EXAMPLE 1)

An organic electroluminescent element was produced through coating fluid application by the following production process. A transparent conductive film of indium-tin oxide (ITO) was deposited in a thickness of 150 nm on a glass substrate by sputtering (sheet resistivity, 15 Ω). This conductive film was patterned by photolithography into stripes having a width of 2 mm to form an anode. The patterned ITO substrate was cleaned by subjecting the substrate to ultrasonic cleaning with acetone, rinsing with pure water, and ultrasonic cleaning with isopropyl alcohol in this order. Thereafter, the substrate was dried by nitrogen blowing and subjected to ultraviolet/ozone cleaning.

The ITO substrate which had been thus cleaned was spin-coated with unconjugated high-molecular compound PB-1, which had an aromatic amino group and had the following structural formula, and with acceptor PI-1, which had the following structural formula, under the following conditions.

[Chem. 36]

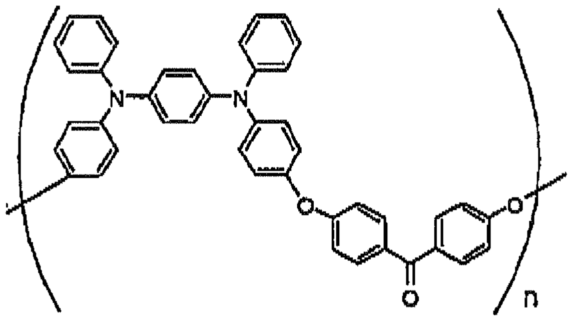

PB-1

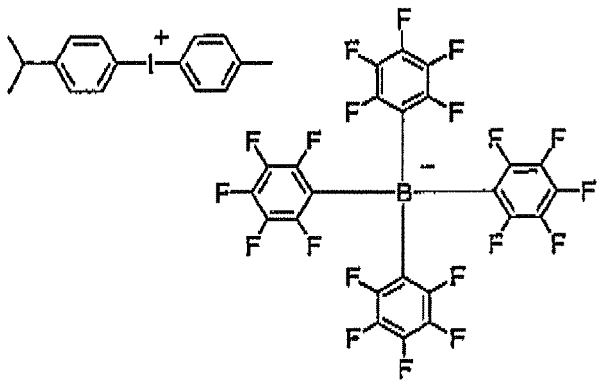

PI-1

Spin Coating Conditions

| | |
|---|---|
| Organic solvent | ethyl benzoate |
| Coating fluid concentration | 2% by weight |
| PB-1/PI-1 | 10/4 |

(continued)

| | |
|---|---|
| Spinner rotation speed | 1,500 rpm |
| Spinner rotation period | 30 sec |
| Drying conditions | 3 hr at 230°C |

By the operation described above, an even and thin hole injection layer having a thickness of 30 nm was formed.

The surface of the thin hole injection layer thus obtained was spin-coated with the following compound HT-1 as a hole-transporting compound under the following conditions.

[Chem. 37]

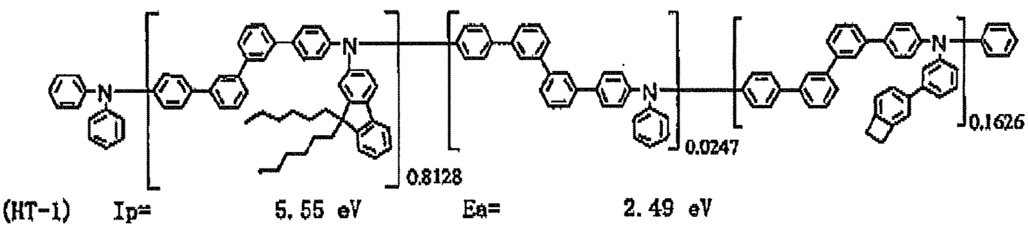

(HT-1) Ip= 5.55 eV Ea= 2.49 eV

Spin Coating Conditions

| | |
|---|---|
| Organic solvent | toluene |
| Coating fluid concentration | 0.4% by weight |
| Spinner rotation speed | 1,500 rpm |
| Spinner rotation period | 30 sec |
| Drying conditions | 60 min at 230°C |

By the operation described above, an even and thin hole transport layer having a thickness of 20 nm was formed.

The surface of the hole transport layer thus obtained was spin-coated with the following charge transport material BH-1 and luminescent material BD-1 under the following conditions.

[Chem. 38]

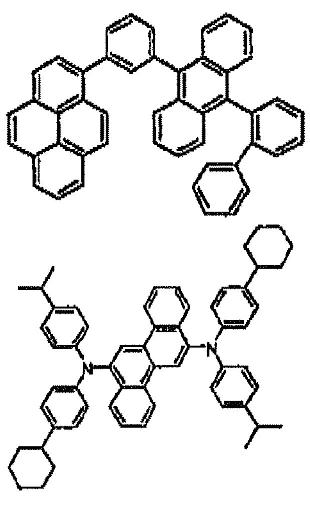

(BH-1) Ip=5.89 eV Ea=2.98eV

(BD-1) Ip=5.52 eV Ea=2.77eV

Spin Coating Conditions

| | |
|---|---|
| Organic solvent | toluene |
| Coating fluid concentration | 0.8% by weight |
| Compounds | BH-1/BD-1=10/1 |
| Spinner rotation speed | 1,200 rpm |
| Spinner rotation period | 30 sec |
| Drying conditions | 60 min at 130°C |

By the operation described above, an even and thin luminescent layer having a thickness of 40 nm was formed.
The following compound HB-1 was deposited in a thickness of 10 nm on the thus-obtained luminescent layer by a vacuum deposition method. Thus, a hole blocking layer was formed.
Subsequently, the following compound ET-1 was deposited in a thickness of 30 nm on the hole blocking layer by a vacuum deposition method. Thus, an electron transport layer was formed.
[Chem. 39]

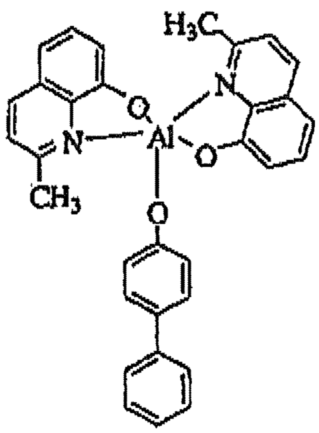

BAlq (HB-1)

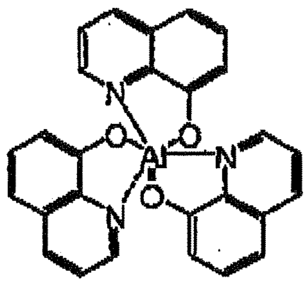

(ET-1)

Lithium fluoride (LiF) was deposited in a thickness of 0.5 nm on the thus-obtained electron transport layer by a vacuum deposition method.
Subsequently, aluminum was deposited thereon in a thickness of 80 nm in the shape of stripes with a width of 2 mm so that the stripes were perpendicular to the ITO stripes each serving as an anode. Thus, a cathode was formed.
By the procedure described above, an organic electroluminescent element which had a luminescent surface having a size of 2 mm × 2 mm was obtained.
The electron affinity of each of the luminescent material, charge transport material, and hole-transporting compound used in Example 1 described above was determined by the method described above, and the values thereof were as shown in Table 1. The ionization potential of each of the luminescent material, charge transport material, and hole-transporting compound used in Example 1 described above was determined by the method which will be described later, and the values thereof were as shown in Table 2. The element produced in Example 1 described above had the properties shown in Table 3.

(COMPARATIVE EXAMPLE 1)

An organic electroluminescent element was produced in the same manner as in Example 1, except that the hole-transporting compound HT-1 was replaced with the following hole-transporting compound HT-2,
**[0382]**

[Chem. 40]

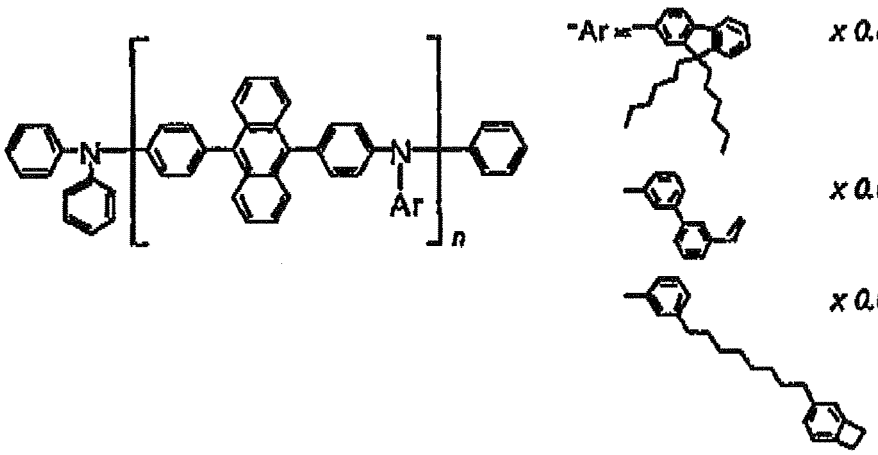

x 0.8274

x 0.0863

x 0.0863

(HT-2) Ip=5.56 eV Ea=2.86eV

The electron affinity and ionization potential of each of the luminescent material, charge transport material, and hole-transporting compound used in Comparative Example 1 were determined by the methods described above, and the values of electron affinity and the values of ionization potential are as shown in Table 1 and Table 2, respectively. The element produced in Comparative Example 1 had the properties shown in Table 3.

(COMPARATIVE EXAMPLE 2)

An organic electroluminescent element was produced in the same manner as in Example 1, except that the hole-transporting compound HT-1 was replaced with the following hole-transporting compound HT-3.

[Chem. 41]

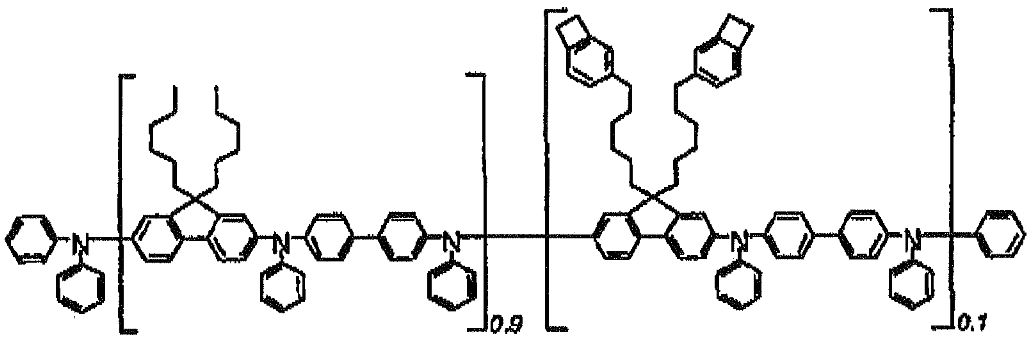

(HT-3) Ip=5.27 eV Ea=2.39eV

The electron affinity and ionization potential of each of the luminescent material, charge transport material, and hole-transporting compound used in Comparative Example 2 were determined by the methods described above, and the values of electron Affinity and the values of ionization potential are as shown in Table 1 and Table 2, respectively. The element produced in Comparative Example 2 had the properties shown in Table 3.

[Table 1]

Table 1

| | $EA_{HTL}$ | $EA_{Dopant}$ | $EA_{Host}$ | $EA_{Host}$-$EA_{Dopant}$ |
|---|---|---|---|---|
| Example 1 | 2.49 eV | 2.77 eV | 2.98 eV | 0.21 eV |
| Comparative Example 1 | 2.86 eV | | | |
| Comparative Example 2 | 2.39 eV | | | |

[Table 2]

Table 2

| | $IP_{Dopant}$ | $IP_{HTL}$ | $IP_{Host}$ | $IP_{Host}$-$IP_{Dopant}$ |
|---|---|---|---|---|
| Example 1 | 5.52 eV | 5.55 eV | 5.89 eV | 0.37 eV |
| Comparative Example 1 | | 5.56 eV | | |
| Comparative Example 2 | | 5.27 eV | | |

[Table 3]

Table 3

| | Maximum luminance ($cd/m^2$) | Operating voltage (V) | Current efficiency (cd/A) | CIE chromaticity coordinates (x, y) | $T_{50}$ Initial luminance, 250 $cd/m^2$ |
|---|---|---|---|---|---|
| Example 1 | 9,081 | 8.8 | 3.9 | 0.137, 0.154 | 7,300 hr |
| Comparative Example 1 | 9,477 | 10.1 | 3.9 | 0.137, 0.184 | 3,300 hr |
| Comparative Example 2 | 5,919 | 9.4 | 2.7 | 0.137, 0.160 | 5,900 hr |

As Table 3 shows, the organic electroluminescent element of the invention had a low operating voltage, a high current efficiency, and a long working life.

(EXAMPLE 2)

An organic electroluminescent element was produced through coating fluid application by the following production process.

A cleaned ITO substrate was produced in the same manner as in Example 1. An even hole injection layer having a thickness of 30 nm was formed on the cleaned ITO substrate in the same manner as in Example 1, except that the drying period was changed from 3 hours to 15 minutes.

A layer of the following compound HT-4 was deposited on the thus-obtained hole injection layer by a vacuum deposition method in a thickness of 20 nm. Thus, a hole transport layer was formed.

[Chem. 42]

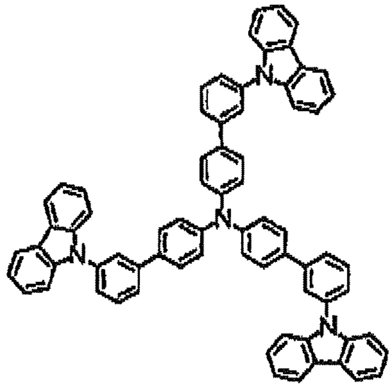

(HT-4) Ip=5.77 eV Ea=2.68 eV

A layer of the following charge transport material BH-2 and luminescent material BD-1 was deposited on the thus-obtained hole transport layer by a vacuum deposition method to form a luminescent layer. This luminescent layer had a thickness of 40 nm and had a composition by weight of BH-2/BD-1=95/5.

[Chem. 43]

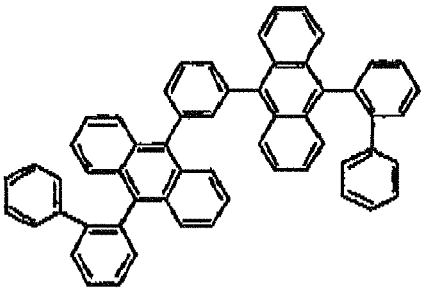

(BH-2) Ip=5.85 eV Ea=2.94eV

A layer of the following compound ET-1 was deposited on the thus-obtained luminescent layer by a vacuum deposition method in a thickness of 30 nm. Thus, an electron transport layer was formed.

A lithium fluoride layer and a cathode were formed on the thus-obtained electron transport layer in the same manner as in Example 1.

By the procedure described above, an organic electroluminescent element which had a luminescent surface having a size of 2 mm × 2 mm was obtained.

The electron affinity and ionization potential of each of the luminescent material, charge transport material, and hole-transporting compound used in Example 2 were determined by the methods described above, and the values of electron affinity and the values of ionization potential are as shown in Table 4 and Table 5, respectively. The element produced in Example 2 had the properties shown in Table 6.

(COMPARATIVE EXAMPLE 3)

An organic electroluminescent element was produced in the same manner as in Example 2, except that the hole-transporting compound HT-4 was replaced with the following hole-transporting compound HT-5.

[Chem. 44]

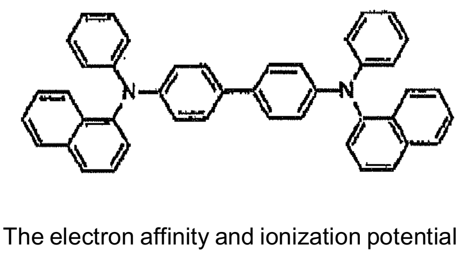

(HT-5) Ip=5.42 eV Ea=2.44eV

The electron affinity and ionization potential of each of the luminescent material, charge transport material, and

hole-transporting compound used in Comparative Example 3 were determined by the methods described above, and the values of electron affinity and the values of ionization potential are as shown in Table 4 and Table 5, respectively. The element produced in Example 2 had the properties shown in Table 6.

[Table 4]

Table 4

| | $EA_{HTL}$ | $EA_{Dopant}$ | $EA_{Host}$ | $EA_{Host}$-$EA_{Dopant}$ |
|---|---|---|---|---|
| Example 2 | 2.68 eV | 2.77 eV | 2.94 eV | 0.17 eV |
| Comparative Example 3 | 2.44 eV | | | |

[Table 5]

Table 5

| | $IP_{Dopant}$ | $IP_{HTL}$ | $IP_{Host}$ | $IP_{Host}$-$IP_{Dopant}$ |
|---|---|---|---|---|
| Example 2 | 5.52 eV | 5.77 eV | 5.85 eV | 0.32 eV |
| Comparative Example 3 | | 5.42 eV | | |

[Table 6]

Table 6

| | Maximum luminance (cd/m$^2$) | Operating voltage (V) | Current efficiency (cd/A) | CIE chromaticity coodinates (x, y) | $T_{50}$ Initial luminance, 250 cd/m$^2$ |
|---|---|---|---|---|---|
| Example 2 | 14,290 | 9.0 | 5.6 | 0.140, 0.155 | 16,300 hr |
| Comparative Example 3 | 10,720 | 7.7 | 4.5 | 0.141, 0.151 | 7,570 hr |

The following terms and symbol used in the Tables have the following meanings.

· Maximum luminance: front luminance at a current of 250 mA/cm$^2$.
· Operating voltage: operating voltage at a front luminance of 2,500 cd/m$^2$.
· Current efficiency: current efficiency at a current of 10 mA/cm$^2$.
· CIE chromaticity coordinates: CIE chromaticity coordinates at a front luminance of 10-1,000 cd/cm$^2$.

$T_{50}$: The period required for the front luminance to decrease to 50% of the initial luminance when the unit is operated at a constant current and an initial front luminance of 250 cd/m$^2$ at room temperature.

As Table 6 shows, the organic electroluminescent element of the invention had a high current efficiency and a long working life.

While the invention has been described in detail and with reference to specific embodiments thereof, it will be apparent to one skilled in the art that various changes and modifications can be made therein without departing from the spirit and scope thereof. This application is based on a Japanese patent application filed on December 11,2009 (Application No. 2009-281978), the entire contents thereof being incorporated herein by reference.

Industrial Applicability

The invention is suitable for use in various fields in which organic electroluminescent elements are used, for example, in the fields of flat panel displays (e.g., displays for OA computers and wall-mounted TV receivers), light sources taking advantage of the feature of a surface light emitter (e.g., the light source of a copier and the backlight of a liquid-crystal display or instrument), display panels, marker lights, and the like.

Description of the Reference Numerals

1 Substrate
2 Anode
3 Hole injection layer
4 Hole transport layer
5 Luminescent layer
6 Hole blocking layer
7 Electron transport layer
8 Electron injection layer
9 Cathode

## Claims

**1.** An organic electroluminescent element comprising an anode, a hole transport layer, a luminescent layer and a cathode, in this order, wherein
the hole transport layer and the luminescent layer have been disposed so as to adjoin each other,
the luminescent layer is a layer which comprises a luminescent material and a charge transport material,
the hole transport layer comprises a hole-transporting compound which has a partial structure shown by the following general formula (5), and
the organic electroluminescent element satisfies the following expressions (1) to (4).

$$EA_{HTL} < EA_{Dopant} \leq EA_{Host} \quad (1)$$

$$0 \leq (EA_{Host} - EA_{Dopant}) \leq 0.7 \text{ eV} \quad (2)$$

$$IP_{Dopant} < IP_{HTL} \leq IP_{Host} \quad (3)$$

$$0 \leq (IP_{Host} - IP_{Dopant}) \leq 0.7 \text{ eV} \quad (4)$$

[In the expressions, $EA_{HTL}$ represents an electron affinity (eV) of the hole-transporting compound,
$EA_{Dopant}$ represents an electron affinity (eV) of the luminescent material,
$EA_{Host}$ represents an electron affinity (eV) of the charge transport material,
$IP_{HTL}$ represents an ionization potential (eV) of the hole-transporting compound,
$IP_{Dopant}$ represents an ionization potential (eV) of the luminescent material, and
$IP_{Host}$ represents an ionization potential (eV) of the charge transport material.]

[Chem. 1]

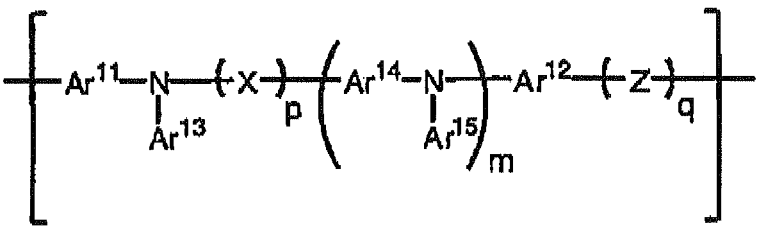

(5)

(In the formula, m represents an integer of 0 to 3, p and q represent an integer of 0 or 1, and
$Ar^{11}$ and $Ar^{12}$ each independently represent a direct bond or an aromatic group which may have a substituent, both of $Ar^{11}$ or $Ar^{12}$ being not a direct bond,
$Ar^{13}$ to $Ar^{15}$ each independently represent an aromatic group which may have a substituent, and when m is 2 or 3, the two or three $Ar^{14}$ groups may be the same or different and the two or three $Ar^{15}$ groups may be the same or different.
X represents an oxygen atom, a sulfur atom which may have a substituent, or a phosphorus atom which may have a substituent.
Z represents a divalent linking group, and
the substituents possessed by $Ar^{11}$ to $Ar^{13}$, $Ar^{15}$, X, and Z each have 60 carbon atoms or less, and the substituent possessed by $Ar^{14}$ has 6 carbon atoms or less.)

2. The organic electroluminescent element according to claim 1, wherein m in general formula (5) represents an integer of 1 to 3.

3. The organic electroluminescent element according to claim 1 or 2, which further comprises a hole injection layer between the anode and the hole transport layer.

4. The organic electroluminescent element according to any one of claims 1 to 3, wherein the luminescent material is at least one of a fluorescent material and a phosphorescent material.

5. An organic EL display device comprising the organic electroluminescent element according to any one of claims 1 to 4.

6. An organic EL illuminator comprising the organic electroluminescent element according to any one of claims 1 to 4.

[Fig. 1]

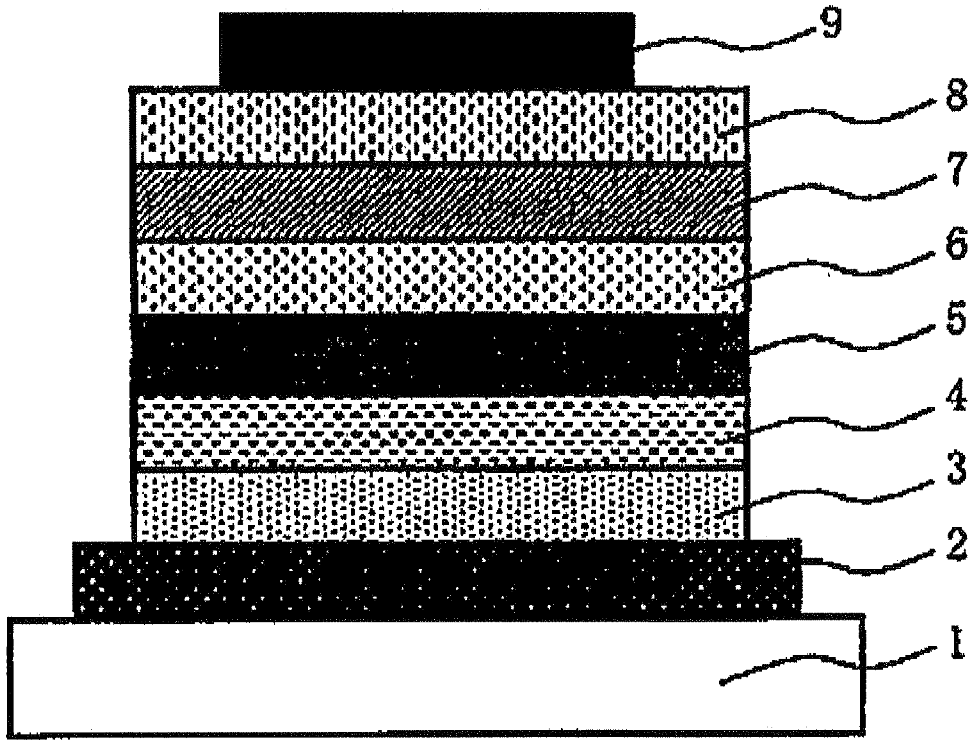

**INTERNATIONAL SEARCH REPORT**

International application No. PCT/JP2010/072292

A. CLASSIFICATION OF SUBJECT MATTER
*H01L51/50*(2006.01)i, *C09K11/06*(2006.01)i

According to International Patent Classification (IPC) or to both national classification and IPC

B. FIELDS SEARCHED

Minimum documentation searched (classification system followed by classification symbols)
H01L51/50, C09K11/06

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2003-282265 A (Matsushita Electric Works, Ltd.),<br>03 October 2003 (03.10.2003),<br>paragraphs [0037], [0038], [0047]<br>(Family: none) | 1-6 |
| X | JP 2001-250690 A (Idemitsu Kosan Co., Ltd.),<br>14 September 2001 (14.09.2001),<br>paragraphs [0054] to [0056], [0062], [0063]<br>& WO 2001/048116 A1 & US 6803120 B2<br>& US 2005/0129982 A1 & US 2007/0134515 A1<br>& US 2009/0179561 A1 & EP 1182244 A1<br>& EP 1905809 A2 & TW 558911 B<br>& TW 593629 B & CN 1342190 A<br>& KR 10-2007-0087028 A & KR 10-2008-0012371 A<br>& KR 10-2008-0012372 A & CN 1011753 A | 1-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 January, 2011 (24.01.11) | 08 February, 2011 (08.02.11) |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.
PCT/JP2010/072292

C (Continuation). DOCUMENTS CONSIDERED TO BE RELEVANT

| Category* | Citation of document, with indication, where appropriate, of the relevant passages | Relevant to claim No. |
|---|---|---|
| X | WO 2009/123269 A1 (Mitsubishi Chemical Corp.), 08 October 2009 (08.10.2009), entire text & JP 2009-263665 A | 1-6 |
| X | WO 2009/102027 A1 (Mitsubishi Chemical Corp.), 20 August 2009 (20.08.2009), entire text & JP 2009-287000 A | 1-6 |
| A | JP 2002-184581 A (Sanyo Electric Co., Ltd.), 28 June 2002 (28.06.2002), paragraph [0122] & US 7201975 B2 & US 2002/0071963 A1 & EP 1215945 A2 | 1 |
| A | JP 2002-313580 A (NEC Corp.), 25 October 2002 (25.10.2002), paragraph [0007] (Family: none) | 1 |
| A | JP 6-313168 A (Idemitsu Kosan Co., Ltd.), 08 November 1994 (08.11.1994), paragraph [0046] & US 5516577 A & EP 569827 A3 & EP 569827 A2 | 1 |
| A | JP 2004-311424 A (Konica Minolta Holdings, Inc.), 04 November 2004 (04.11.2004), claims; paragraph [0320] & US 2004/0189190 A1 & EP 1464691 A2 | 1-6 |
| A | WO 2009/119591 A1 (Fuji Electric Holdings Co., Ltd.), 01 October 2009 (01.10.2009), paragraphs [0051] to [0068] (Family: none) | 1-6 |
| A | JP 2008-179190 A (Mitsubishi Chemical Corp.), 07 August 2008 (07.08.2008), paragraph [0314] (Family: none) | 1-6 |
| A | JP 2009-196982 A (Mitsubishi Chemical Corp.), 03 September 2009 (03.09.2009), paragraph [0273] (Family: none) | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- JP 2007311759 A
- US 20090200925 A
- JP 2006352088 A
- JP 2006128636 A
- WO 2005019373 A
- JP 5234681 A
- WO 2005089024 A
- JP 11242996 A
- JP 7041759 A
- JP 10079297 A
- JP 2005022962 A
- JP 59194393 A
- US 5645948 A
- JP 6207169 A
- JP 5331459 A
- JP 10270171 A
- JP 2002100478 A
- JP 2002100482 A
- JP 2009281978 A

### Non-patent literature cited in the description

- *Journal of Luminescence,* 1997, vol. 72-74, 985
- *Synthetic Metals,* 1997, vol. 91, 209
- *Appl. Phys. Lett.,* 1992, vol. 60, 2711
- **TOKITO SHIZUO ; ADACHI CHIHAYA ; MURATA HIDEYUKI.** ki EL Dispurei. Ohmsha, Ltd, 20 August 2004